(19) Europäisches Patentamt / European Patent Office / Office européen des brevets

(11) **EP 4 651 181 A1**

(12) **EUROPEAN PATENT APPLICATION**
published in accordance with Art. 153(4) EPC


(43) Date of publication:
**19.11.2025 Bulletin 2025/47**

(21) Application number: **25746815.7**

(22) Date of filing: **05.03.2025**

(51) International Patent Classification (IPC):
***H01L 21/02*** *(2006.01)* ***B32B 15/01*** *(2006.01)*
***C09J 183/00*** *(2006.01)*

(86) International application number:
**PCT/JP2025/008042**

(87) International publication number:
**WO 2025/204645 (02.10.2025 Gazette 2025/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2024 JP 2024056794**



(71) Applicant: **DAIKIN INDUSTRIES, LTD.**
**Osaka-Shi, Osaka 530-0001 (JP)**

(72) Inventors:
- **OHMUKAI, Yoshikage**
**Osaka-Shi, Osaka 5300001 (JP)**
- **NAKAGAWA, Chihiro**
**Osaka-Shi, Osaka 5300001 (JP)**
- **HOSODA, Kazuki**
**Osaka-Shi, Osaka 5300001 (JP)**
- **NAMIKAWA, Takashi**
**Osaka-Shi, Osaka 5300001 (JP)**

(74) Representative: **Hoffmann Eitle**
**Patent- und Rechtsanwälte PartmbB**
**Arabellastraße 30**
**81925 München (DE)**


(54) **METHOD FOR MANUFACTURING LAMINATE INCLUDING TWO SILICON SUBSTRATES, AND LAMINATE**


(57) A method for producing a layered product including two silicon substrates, comprising:
(a) providing a first silicon substrate having a first bonding part and a second silicon substrate having a second bonding part, wherein the first bonding part and the second bonding part each include silicon oxide;
(b) providing a first composition including at least one of an organic material reactable with a hydrosilyl group and/or a silanol group, and an inorganic material bondable to silicon oxide, and having an amount of particles of 3,000 pieces/mL or less; and
(c) with use of at least one of the organic material and the inorganic material, disposing an adhesive layer that bonds the first bonding part and the second bonding part with the organic material and/or a reaction product derived from the organic material, or bonds the first bonding part and the second bonding part with the inorganic material and/or a reaction product derived from the inorganic material,

wherein the adhesive layer includes a first adhesive part disposed on the first bonding part, and
the number of clusters of the particles included in the surface of the first adhesive part on the opposite side of the first bonding part is 5 pieces/$cm^2$ or less.


[Fig. 1]

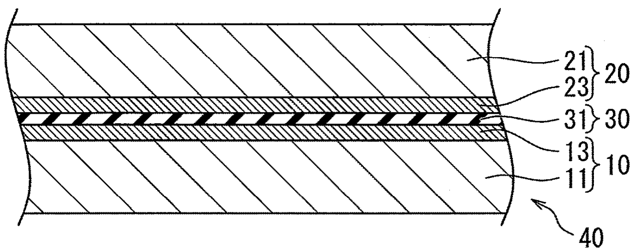


EP 4 651 181 A1

## Description

Technical Field

The present invention relates to a method for producing a layered product including two silicon substrates and the layered product.

Background Art

In the field of semiconductor technology, for example, in Patent Literature 1, disposing an adhesive layer between silicon substrates has been studied as a method for bonding two silicon substrates.

Citation List

Patent Literature

Patent Literature 1: WO 2023/276638 A1

Summary of Invention

Technical Problem

In the adhesion of silicon substrates, it has been required to make a larger adhesion strength between the silicon substrates. Accordingly, an object of the present invention is to provide a production method for making a larger adhesion strength between the silicon substrates, and a layered product formed by the production method.

Solution to Problem

In order to solve the problem, the present disclosure provides the following [1] to [17].

[1] A method for producing a layered product including two silicon substrates, comprising:

(a) providing a first silicon substrate having a first bonding part and a second silicon substrate having a second bonding part, wherein the first bonding part and the second bonding part each include silicon oxide;
(b) providing a first composition including at least one of an organic material reactable with a hydrosilyl group and/or a silanol group, and an inorganic material bondable to silicon oxide, and having an amount of particles of 3,000 pieces/mL or less; and
(c) with use of at least one of the organic material and the inorganic material, disposing an adhesive layer that bonds the first bonding part and the second bonding part with the organic material and/or a reaction product derived from the organic material, or bonds the first bonding part and the second bonding part with the inorganic material and/or a reaction product derived from the inorganic material,

wherein the adhesive layer includes a first adhesive part disposed on the first bonding part, and
the number of clusters of the particles included in the surface of the first adhesive part on the opposite side of the first bonding part is 5 pieces/$cm^2$ or less.

[2] The production method according to [1],
wherein the organic material has at least one selected from the group consisting of an alkenyl group, a hydroxyl group, a hydrolyzable silyl group, an isocyanate group, an epoxy group, an amino group, an acid anhydride group and a siloxane bond.
[3] The method for producing a layered product according to [1] or [2],
wherein the organic material includes at least one selected from the group consisting of:

(i) a hydrocarbon compound having an alkenyl group at two terminal parts;
(ii) a substituted or unsubstituted hydrocarbon compound having an alkenyl group at one terminal part, and any one selected from the group consisting of a hydroxy group, a hydrolyzable silyl group, an isocyanate group, an epoxy group, an amino group, and an acid anhydride group at another terminal part;
(iii) a substituted or unsubstituted hydrocarbon compound having a plurality of terminal parts, wherein at least two

terminal parts, each independently have any one selected independently from a hydroxyl group, a hydrolyzable silyl group, an isocyanate group, an epoxy group, an amino group, a phosphate group, and an acid anhydride group; and
(iv) silsesquioxane and a derivative thereof.

[4] The production method according to any one of [1] to [3], wherein the reaction product is derived from the inorganic material.
[5] The production method according to [4], wherein the reaction product includes at least one selected from the group consisting of $SiO_2$, SiOC, SiOF, SiN, SiCN, $HfO_2$, and $La_2O_3$.
[6] The production method according to any one of [1] to [5], comprising filtering a second composition for purification into the first composition.
[7] The production method according to [6], wherein the filtering is performed using a membrane having an effective diameter of 50 nm or less.
[8] The production method according to [6] or [7], wherein the amount of particles in the second composition is more than 3,000 pieces/mL.
[9] The production method according to any one of [1] to [8], wherein a bonding strength between the first silicon substrate and the second silicon substrate is 1.00 $J/m^2$ or more.
[10] The production method according to any one of [1] to [9], wherein the first adhesive part includes two or more layers.
[11] The production method according to any one of [1] to [10],

wherein the adhesive layer further has a second adhesive part bonding to the first adhesive part,
the second adhesive part is disposed on the second bonding part, and
the number of clusters of particles included in the surface of the second adhesive part on the opposite side of the second bonding part is 5 pieces/$cm^2$ or less.

[12] The production method according to [11], wherein the second adhesive part includes two or more layers.
[13] The production method according to [11] or [12],
wherein the organic material comprises at least one selected from the group consisting of:

(i) a substituted or unsubstituted hydrocarbon compound having a plurality of terminal parts, wherein at least two terminal parts have an alkenyl group;
(ii) a substituted or unsubstituted hydrocarbon compound having a plurality of terminal parts, wherein at least one terminal part has an alkenyl group, and at least one terminal part has any one selected from the group consisting of a hydroxyl group, a hydrolyzable silyl group, an isocyanate group, an epoxy group, an amino group, and an acid anhydride group;
(iii) a substituted or unsubstituted hydrocarbon compound having a plurality of terminal parts, wherein at least two terminal parts, each independently have any one selected independently from the group consisting of a hydroxyl group, a hydrolyzable silyl group, an isocyanate group, an epoxy group, an amino group, a phosphate group, and an acid anhydride group;
(iv) silsesquioxane and a derivative thereof;
(v) a hydrolyzable hydrosilane or a combination of a substituted or unsubstituted hydrocarbon compound having a hydrolyzable silyl group at one terminal part and a hydrosilyl group at the other terminal part, and a substituted or unsubstituted hydrocarbon compound having a hydrolyzable silyl group at one terminal part and an alkenyl group at the other terminal part; and
(vi) a substituted or unsubstituted hydrocarbon compound having a hydrolyzable silyl group at one terminal part and an alkyl group at the other terminal part.

[14] A layered product comprising:

a first silicon substrate having a first bonding part;
a second silicon substrate having a second bonding part which is located on the side of the first bonding part; and
an adhesive layer that is located between the first bonding part and the second bonding part and that allows the first bonding part and the second bonding part to adhere to each other;
wherein the first bonding part and the second bonding part have a hydrosilyl group and/or a silanol group derived from silicon oxide, or a region bonding to an inorganic material;
the adhesive layer includes a reaction product of a reaction with the hydrosilyl group and/or the silanol group, or a region bonding to the inorganic material;

the number of clusters of particles on the surface of the adhesive layer is 5 pieces/$cm^2$ or less; and
the bonding strength between the first silicon substrate and the second silicon substrate is 1.00 J/$m^2$ or more.

[15] The layered product according to [14], wherein the adhesive layer includes 2 or more layers.
[16] A composition comprising at least one of an organic material and an inorganic material, and having an amount of particles of 3,000 pieces/mL or less.
[17] The composition according to [16], for use in the production method according to claim 1.

Advantageous Effects of Invention

According to the present disclosure, a production method for making a larger adhesion strength between silicon substrates, and a layered product formed by the production method can be provided.

Brief Description of Drawings

[Figure 1] Figure 1 is a schematic cross-sectional diagram showing a layered product in a first embodiment.
[Figure 2] Figure 2 is a schematic cross-sectional diagram showing a layered product in a second embodiment.
[Figure 3] Figure 3 is a schematic cross-sectional diagram showing a layered product in a modified example.

Description of Embodiments

Embodiments of the present disclosure will be described in detail below with reference to drawings, though the present disclosure is not limited thereto.

<First embodiment>

Figure 1 is an explanatory drawing, schematically showing a cross section of a layered product 40 in a first embodiment. As shown in Figure 1, the layered product 40 has a first silicon substrate 10 and a second silicon substrate 20, with an adhesive layer 30 located between the first silicon substrate 10 and the second silicon substrate 20. The first silicon substrate 10 has a first body part 11 and a first bonding part 13. The second silicon substrate 20 has a second body part 21 and a second bonding part 23. The first bonding part 13 and the second bonding part 23 are bonded through the adhesive layer 30.
The layered product 40 may be obtained by a production method including the following steps.

(a) providing a first silicon substrate 10 having a first bonding part 13 including silicon oxide, and a second silicon substrate 20 having a second bonding part 23 including silicon oxide;
(b) providing a first composition including at least one of an organic material reactable with a hydrosilyl group and/or silanol, and an inorganic material bondable to silicon oxide, and having an amount of particles of 3,000 pieces/mL or less; and
(c) with use of at least one of the organic material and the inorganic material, bonding the first bonding part 13 and the second bonding part 23 with the organic material and/or a reaction product derived from the organic material, or providing an adhesive layer 30 bonding the first bonding part 13 and the second bonding part 23 with the inorganic material;

wherein the adhesive layer 30 includes a first adhesive part 31 disposed on the first bonding part 13, and
the number of clusters of particles included in the surface of the first adhesive part 31 on the opposite side of the first bonding part 13 is 5 pieces/$cm^2$ or less.

With use of the production method, the bonding strength between the first and second silicon substrates 10 and 20 can be increased. In the present specification, "an organic material and/or a reaction product derived from the organic material" may be described as "a reaction product derived from an organic material".
In the following, each step is described. In the following, unless otherwise specified, "on first silicon substrate 10" may mean a state in direct contact with the first silicon substrate 10, or a state including another layer or the like on the first silicon substrate 10. The same applies to other substrates, layers or regions.

[Step a]

First, a first silicon substrate 10 having a first bonding part 13 and a second silicon substrate 20 having a second bonding part 23 are provided. The first bonding part and the second bonding part 23 are the parts that include silicon oxide.

(First and second silicon substrates 10 and 20)

The first and second silicon substrates 10 and 20 (hereinafter collectively also referred to simply as "silicon substrates") may be silicon-based substrates (or bases) and may be made of silicon or may contain any other appropriate substance in addition to silicon. Examples of the substance include a dopant, impurities that may be inevitably mixed, metal (e.g., electrodes, wiring and vias), an oxide, nitride and/or carbide of silicon or the like (e.g., a dielectric layer, insulating layer and protecting layer).

The first silicon substrate 10 and the second silicon substrate 20 may have the same structure or different structure. In an aspect, the first silicon substrate 10 and the second silicon substrate have the same structure. In an aspect, the first silicon substrate 10 and the second silicon substrate have a structure different from each other.

The first silicon substrate 10 has a first body part 11 and a first bonding part 13. The first body part 11 is an unprocessed silicon substrate, with the surface of the first body part 11 provided with a first bonding part 13. The first bonding part 13 may include the whole of the surface of the first silicon substrate 10 (typically one of the two surfaces facing each other of the first silicon substrate 10), or may include a part of the region.

The second silicon substrate 20 has a second body part 21 and a second bonding part 23. The second body part 21 is an unprocessed silicon substrate, with the surface of the second body part 21 provided with a second bonding part 23. The second bonding part 23 may constitute the whole of the surface of the second silicon substrate 20 (typically one of the two surfaces facing each other of the second silicon substrate 20), or constitute a part of the region.

(First and second bonding parts 13 and 23)

In the present embodiment, the first and second bonding parts 13 and 23 (in the following, also referred to as "bonding part") may be a part that includes silicon oxide (in the following, also referred to as "silicon oxide part"). The silicon oxide portion may be made of silicon oxide or may include any other suitable substances in addition to silicon oxide. Examples of the other substances include a dopant and impurities that may be inevitably mixed.

The bonding part can be formed, for example, by oxidizing the whole or a part of the surface of a silicon substrate (typically, one of the two surfaces of silicon substrate facing each other). In other words, the first bonding part 13 may be composed of whole surface of the first silicon substrate 10 (typically, one of the two surfaces of the silicon substrate 10 facing each other), or may be composed of a part thereof. The second bonding part 23 may be composed of whole surface of the second silicon substrate 20 (typically, one of the two surfaces of the silicon substrate 20 facing each other), or may be composed of a part thereof.

Oxidation of silicon may be performed by heating in an atmosphere containing oxygen (so-called thermal oxidation) and/or by natural oxidation. Alternatively, for example, the bonding part of the present embodiment may be formed by depositing silicon oxide on the entire surface or a partial region of the surface of a silicon substrate (typically, one of the two surfaces of silicon substrates facing each other). The deposition of silicon oxide may be performed by any one of sputtering, chemical vapor deposition (CVD), plasma enhanced chemical vapor deposition (PECVD), vapor deposition, or by any combination of two or more thereof. Alternatively, a combination of oxidation of silicon and deposition of silicon oxide may be performed. However, the method for forming the bonding part as silicon oxide portion is not limited thereto, and it may be formed by any suitable method.

On the surface of the bonding part as silicon oxide portion, silanol groups (-Si-OH) are present.

The thickness of the bonding part is not limited as long as the layered product finally produced achieves desired or acceptable characteristics. For example, each of the thickness of the bonding part, which is a part made of silicon oxide, can be 1 nm or more and 1 $\mu$m or less, particularly 10 nm or less. The thickness of the bonding part may be measured, for example, using a transmission electron microscope. Alternatively, in the case of before bonding, the thickness of the bonding part may be measured by ellipsometry. Preferably, the thickness of the bonding part (in both of before bonding and after bonding) is measured by ellipsometry.

Though not necessarily required for the present embodiment, it is preferable that at least one of the first bonding part 13 and the second bonding part 23 be subjected to a surface treatment to generate a hydrosilyl group and/or a silanol group, after the step (a) and before the step (c). Thereby, hydrosilyl groups (-Si-H) and/or silanol groups (-Si-OH) can be present at a higher density on the surface of the bonding part. The surface treatment may be performed on the surface of the bonding part (bonding surface), and may be performed on the surface of the bonding part only or on a wider surface including the surface of the bonding part. The abundance ratio of the hydrosilyl group and the silanol group in the surface of the bonding part may be measured by, for example, time-of-flight secondary ion mass spectrometry (TOF-SIMS). For

example, the abundance ratio of the silanol group (-Si-OH) may be measured by determining the ratio of -Si-OH relative to $-C_4H_7$. The ratio of -Si-OH relative to $-C_4H_7$ means the ratio of the number of fragmented ions.

The surface treatment that generates hydrosilyl groups and/or silanol groups may be at least one selected from hydrogen atom processing, heat treatment in hydrogen-containing atmosphere, sputtering, chemical vapor deposition (CVD), plasma processing and terminal treatment using a chemical solution. By the hydrogen atom processing, heat treatment in hydrogen-containing atmosphere, sputtering, chemical vapor deposition (CVD), plasma processing or terminal treatment using a chemical solution, hydrogen atoms are introduced on the surface of the bonding part, so that hydrosilyl groups (-Si-H) can be generated. By the terminal treatment with a chemical solution, hydroxyl groups can be introduced on the surface of the bonding part to produce silanol groups (-Si-OH).

The hydrogen atom treatment may be performed, for example, by supplying hydrogen gas at about $1\times10^{-4}$ Pa into a vacuum chamber at an ultra-high vacuum ($1\times10^{-6}$ Pa or less), and dissociating hydrogen molecules into hydrogen atoms by thermal electrons or plasma, so that hydrogen atoms are adsorbed on the surface of the bonding part.

The heat treatment in a hydrogen-containing atmosphere may be performed, for example, by flowing hydrogen as a carrier gas during evacuation to replace the atmosphere in the chamber with hydrogen gas to create a vacuum state of a hydrogen atmosphere (specifically, hydrogen atmosphere at 10 Pa or less), and heating the substrate to about 100 to 400°C in the atmosphere, so that hydrogen is adsorbed on the surface of the bonding part.

The sputtering treatment may be performed, for example, by using silicon as sputtering source, and supplying hydrogen to be adsorbed on the surface of the bonding part.

The CVD treatment may be performed, for example, by using silane as CVD gas, and adjusting the gas pressure of hydrogen such that hydrogen atoms are adsorbed on the surface of the bonding part.

The plasma processing may be performed, for example, by plasma processing a silicon substrate and then causing a reaction between the surface of the substrate and water molecules in the atmosphere or in a water bath.

The terminal treatment using a chemical solution may be performed, for example, by immersing a silicon substrate in chemical solution such as aqueous solution of hydrofluoric acid (fluoric acid), ammonium fluoride, and formic acid, with at least the bonding part exposed, such that the hydrogen ions and/or hydroxide ions are bonded to the surface of the bonding part.

Though not necessarily required for the present embodiment, at least one of the first bonding part 13 and the second bonding part 23 may be subjected to a surface treatment to generate a fluorosilyl group, after the step (a) and before the step (c).

The surface treatment to produce fluorosilyl groups may be at least one selected from the group consisting of CVD, discharge treatment, ion implantation, plasma processing and terminal treatment with a chemical solution. The surface treatment to produce fluorosilyl groups may be performed separately or simultaneously with the surface treatment to produce hydrosilyl groups and/or silanol groups. In the case of a separate treatment, any one of the surface treatments may be performed first.

The CVD treatment may be performed using, for example, $CF_4$ and/or $SF_6$ as CVD gas to adsorb fluorine atoms onto the surface of the bonding part.

The discharge treatment may be performed, for example, by plasma discharging or corona discharging in an atmosphere containing $CF_4$ and/or $SF_6$ to adsorb fluorine radicals on the surface of the bonding part.

The ion implantation may be performed by implanting fluorine ions into the bonding part by any suitable method.

The terminal treatment with a chemical solution may be performed, for example, by immersing a silicon substrate in a chemical solution such as hydrofluoric acid aqueous solution (hydrofluoric acid) or a chemical solution of ammonium fluoride with at least the bonding part exposed, such that fluorine ions are bound to the surface of the bonding part depending on the chemical solution used. In particular, the terminal treatment with a hydrofluoric acid aqueous solution allows hydrosilyl groups (-Si-H), silanol groups (-Si-OH), and fluorosilyl groups (-Si-F) to be produced.

Though not necessarily required for the present embodiment, the surface of the silicon substrate before being provided with the bonding part may be subjected to chemical mechanical polishing (CMP). Thereby, planarization or smoothing of the surface is achieved.

Further, though not necessarily required for the present embodiment, before providing the bonding part, the surface of the silicon substrate may be subjected to cleaning after CMP or without CMP. Thereby, the surface can be cleaned, or, unnecessary substances such as organic materials, particles, metal and/or metal ions can be removed.

Cleaning may be performed by a known method in the field of semiconductor technology, though not limited thereto. The cleaning may include washing and drying. The washing may be performed using at least any one or a combination of optional two or more of washing liquids such as SPM ($H_2SO_4+H_2O_2+H_2O$: piranha solution), APM ($NH_4OH+H_2O_2+H_2O$: SC-1, RCA-1), HPM ($HCl+H_2O_2+H_2O$: SC-2, RCA-2), DHF ($HF+H_2O$) and BHF ($NH_4F+HF+H_2O$) (these may be a standard composition or a modified composition). Washing may be performed with appropriate addition of any one or a combination of optional two or more of trichloroethylene, alcohol, acetone, deionized water and ultrasonic waves. Further, spin drying, isopropanol (IPA) vapor drying or IPA direct replacement drying may be applied.

Depending on the chemical solution and conditions for cleaning, ions or molecules such as $OH^-$, $H^+$, $H_2O$, $H_2$ and

$O_2$ may be introduced onto the surface of the silicon substrate before providing a bonding part, so that hydrosilyl groups and/or silanol groups may be generated on the surface.

The first silicon substrate 10 and the second silicon substrate 20 are provided as described above.

[Step b]

Subsequently, a first composition that contains at least one of an organic material reactable with a hydrosilyl group and/or a silanol group and an inorganic material bondable to silicon oxide, and has particles in an amount of 3,000 pieces/mL or less, is provided. The lower limit of the amount of particles in the first composition is, for example, 1 piece/mL or more, specifically 0 piece/mL or more, though not limited thereto.

(First composition containing organic material or inorganic material)

At least one of the organic material and the inorganic material is used as a first composition that contains, for example, a solvent. The first composition may contain a solvent and a reaction accelerator such as an acid catalyst or basic catalyst, in addition to the organic material and/or the inorganic material. As the solvent, one that is usually used may be used, and for example, propylene glycol monomethyl ether acetate, propylene glycol monomethyl ether, toluene, tetrahydrofuran, or isopropyl alcohol may be used. The water content in the first composition is substantially zero. With such a low water content in the first composition, occurrence of voids can be suppressed. The first composition may include an organic material or an inorganic material only, or may include an organic material and an inorganic material only.

The first composition may include an organic material and/or an inorganic material in a solvent, in a dissolved, dispersed or suspended state. For example, the first composition dissolves an organic material and/or an inorganic material.

The amount of particles in the first composition is, for example, 3,000 pieces/mL or less, preferably 2,000 pieces/mL or less, more preferably 1,000 pieces/mL or less, and may be, for example, 500 pieces/mL or less. The lower limit of the amount of particles in the first composition may be, for example, 0 piece/mL or more, though not limited thereto.

The particle may be a single particle or may be an aggregate of particles. In other words, the particle includes a primary particle and a secondary particle. Further, the particle may be made of inorganic substance or organic substance. Examples of the particle include one that exists in a particle shape after curing of organic material, such as a particle that exists in the environment and a particle that is supplied together with the organic material.

The amount of particles may be measured by using, for example, syringe sampling system SLS-1040.

The content of an organic material and/or an inorganic material in the first composition is preferably 50 mass% or less, more preferably 35 mass% or less, still more preferably 30 mass% or less. The lower limit of an organic material and/or an inorganic material may be, for example, 1 mass% or more, 3 mass% or more, or 5 mass% or more, though not limited thereto. For example, the content of an organic material and/or an inorganic material in the first composition may be in the range of 1 to 50 mass%, in the range of 3 to 35 mass%, or in the range of 5 to 30 mass%. Further, the content of an organic material and/or an inorganic material in the first composition may be in the range of 1 to 30 mass%, or in the range of 3 to 30 mass%. In the case of containing an organic material and an inorganic material, total of both materials may be in the range.

Preferably, the first composition contains a solvent and an organic material and/or an inorganic material, only.

(Organic material in first composition)

The amount of particles in the organic material is, for example, 3,000 pieces/mL or less, preferably 2,000 pieces/mL or less, more preferably 1,000 pieces/mL or less, and may be, for example, 500 pieces/mL or less. The lower limit value of the amount of particles in the organic material may be, for example, 0 piece/mL or more, though not limited thereto. The amount of particles in the organic material may be measured, for example, by the same method as for the amount of particles in the first composition.

The organic material has preferably at least two functional groups. It is preferable that the two functional groups be located at both terminal parts of the organic material.

The organic material may react with a hydrosilyl group and/or a silanol group to form a reaction product at a functional group of one terminal part. In other words, the structure of the reaction product depends on the construction of the organic material.

The organic material may be reactable with the second activated region 23a at a functional group of another terminal part. The first bonding part 13 and the second bonding part 23 are bonded with the reaction product derived from the organic material.

Examples of the functional group include at least one selected from the group consisting of an alkenyl group, a hydroxyl group, a hydrolyzable silyl group, an isocyanate group, an epoxy group, an amino group, an acid anhydride group

and a siloxane bond.

An alkenyl group is reactable with a hydrosilyl group (-Si-H), and a hydroxyl group, a hydrolyzable silyl group, an isocyanate group, an epoxy group, an amino group, an acid anhydride group and a siloxane bond are reactable with a silanol group (-Si-OH).

More specifically, the organic material may include at least one selected from the group consisting of the following (i) to (iv). As the organic material, one compound may be used or a combination of two or more compounds may be used.

(i) A substituted or unsubstituted hydrocarbon compound having a plurality of terminal parts, wherein at least two terminal parts have an alkenyl group at.

(ii) A substituted or unsubstituted hydrocarbon compound having a plurality of terminal parts, wherein at least one terminal part has an alkenyl group at, and at least one terminal part has any one selected from the group consisting of a hydroxyl group, a hydrolyzable silyl group, an isocyanate group, an epoxy group, an amino group, and an acid anhydride group.

(iii) A substituted or unsubstituted hydrocarbon compound having a plurality of terminal parts, wherein at least two terminal parts have any one selected independently from a hydroxyl group, a hydrolyzable silyl group, an isocyanate group, an epoxy group, an amino group, a phosphate group, and an acid anhydride group.

(iv) Silsesquioxane and a derivative thereof.

The details of (i) to (iv) are described as follows.

(Inorganic material in first composition)

The amount of particles in the inorganic material is, for example, 3,000 pieces/mL or less, preferably 2,000 pieces/mL or less, more preferably 1,000 pieces/mL or less, and may be, for example, 500 pieces/mL or less. The lower limit of particles in the inorganic material may be, for example, 0 piece/mL or more, though not limited thereto. The amount of particles in the first composition may be measured, for example, by the same method for measuring the amount of particles in the first composition.

The inorganic material may form a reaction product through a reaction with a hydrosilyl group and/or a silanol group. The reaction product may include at least one selected from the group consisting of $SiO_2$, SiOC, SiOF, SiN, SiCN, $HfO_2$ and $La_2O_3$. Incidentally, without a reaction between the inorganic material and the first silicon substrate 10 or the second silicon substrate 20, a layer derived from the inorganic material may be provided on the first silicon substrate 10 or the second silicon substrate 20. In this case, the layer derived from the inorganic material may include at least one selected from the group consisting of, for example, $SiO_2$, SiOC, SiOF, SiN, SiCN, $HfO_2$ and $La_2O_3$.

From the inorganic material, at least one thin film may be formed. The thickness of the thin film is, for example, 10 nm or less, though not limited thereto.

Preferably, filtering the second composition for purification into the first composition is included. Thereby, particles contained in the second composition are removed, so that the amount of particles contained in the first adhesive part 31 can be reduced. The organic material or the like contained in the second composition has the same structure as of the organic material contained in the first composition except for the amount of particles. The amount of particles in the second composition is, for example, more than 3,000 pieces/mL.

Preferably, the filtering is performed using a membrane having an effective diameter of 50 nm or less. The effective diameter of the membrane is more preferably 10 nm or less. The lower limit of the effective diameter of the membrane may be, for example, 1 nm or more, though not limited thereto. The effective diameter means the value of average effective diameter of the membrane.

[Step c]

Subsequently, at least one of the organic material or the inorganic material is supplied between the first bonding part 13 and the second bonding part 23 to provide an adhesive layer 30 that bonds the first bonding part 13 and the second bonding part 23 with a reaction product derived from the organic material, or bonds the first bonding part 13 and the second bonding part 23 with the inorganic material.

(Adhesive layer 30)

The adhesive layer 30 includes a first adhesive part 31 provided on the first bonding part 13. In the present embodiment, the first silicon substrate 10 and the second silicon substrate 20 are bonded with the first adhesive part 31. The number of clusters of particles contained in the surface of the first adhesive part 31 on the opposite side of the first bonding part 13 is 5 pieces/$cm^2$ or less. The lower limit of the number of clusters of particles on the surface of the adhesive

layer 30 is, for example, 1 piece/$cm^2$ or more, specifically 0 piece/$cm^2$ or more, though not limited thereto. The number of clusters of particles may be measured as follows. At least one of an organic material (or a composition including an organic material) and an inorganic material (or a composition including an inorganic material) is disposed on a silicon substrate separately prepared (for example, the surface of the first silicon substrate 10 on the side of the first bonding part 13), then the organic material (or a composition containing the organic material) and the inorganic material (or a composition containing the inorganic material) are dried, and the surface after drying is subjected to the measurement.

A cluster means an aggregate of particles (also referred to as "surface particles") present on the surface. For example, in a cluster, one particle may be present alone, or two or more particles may be present in a solidified state. The number of particles contained in a cluster is, for example, 30 pieces or less, though not limited thereto.

The number of clusters may be measured using a surface foreign matter inspecting device. As the surface foreign matter inspecting device, a typical device for the inspection in the previous step may be used. The measurement object may be, for example, a 300-mm wafer. For example, in the case where the adhesive layer 30 has a small thickness, the particle size may be larger than the thickness of the adhesive layer 30. In this case, the measurement using a surface foreign matter inspecting device may be particularly useful.

With a number of clusters of particles on the surface of the adhesive layer 30 in the range, the bonding strength between the first silicon substrate 10 and the second silicon substrate 20 is enhanced. Further, the layered product 40 can be produced at a relatively low temperature, so that the occurrence of voids in the adhesive layer 30 can be effectively suppressed or prevented. The bonding strength may be measured, for example, by a blade test. For example, the measurement may be performed by a blade test, in which a razor blade is inserted between wafers to observe the peeling distance with an infrared microscope. The bonding strength $\gamma$ is represented by the following formula.

$$\gamma=(3Ed^3y^2)/(32L^4)$$

wherein, E is Young's modulus of wafer, y is thickness of blade, d is thickness of wafer, and L is peeling distance.

The lower limit of the number of clusters of particles in the adhesive layer 30 is, for example, 0 piece/$cm^2$ or more, though not limited thereto.

The number of clusters of particles on the surface of the adhesive layer 30 may be, for example, 3,000 pieces/wafer or less, 2,000 pieces/wafer or less, or 1,000 pieces/wafer or less. The lower limit of the number of clusters on the surface of the adhesive layer 30 may be 0 piece/wafer or more, or 1 piece/wafer or more, though not limited thereto. The wafer is a 300-mm wafer, having a diameter of 300 mm, with an area of 706.8 $cm^2$.

The particle size of particles on the adhesive layer may be, for example, 60 nm or more, or 200 nm or more. The upper limit of the particle size of the particle may be, for example, 6 $\mu$m or less, though not limited.

The particle size of a particle means light-scattering equivalent size that can be quantitatively determined by a measurement device. The particle size can be measured, for example, by using a surface foreign matter inspecting device or a liquid particle counter. The particle size may be measured, for example, using a surface foreign matter inspecting device capable of measuring a particle size of 60 nm or more.

The amount of particles on the surface of the adhesive layer 30 may be, for example, 3,000 pieces/$cm^2$ or less, 2,000 pieces/$cm^2$ or less, or 1,000 pieces/$cm^2$ or less. The lower limit of the amount of particles on the surface of the adhesive layer 30 may be 0 piece/$cm^2$ or more, or 1 piece/$cm^2$ or more.

Incidentally, although the first adhesive part 31 is provided on the first bonding part 13 in the first embodiment, the first adhesive part 31 may be provided on the second bonding part 23. In this case, "first bonding part 13" is deemed to be replaced with "second bonding part 23", and "first bonding part 13" is deemed to be replaced with "second bonding part 23".

The adhesive layer 30 (first adhesive part 31) may include two or more layers. In other words, an adhesive part as the first layer is disposed on the first silicon substrate 10, dried and/or heated on an as needed basis, and then an adhesive layer as the second layer may be disposed. The number of layers of the adhesive part may be, for example, three or less, though not limited thereto.

The thickness of the adhesive layer 30 may be extremely thin. The thickness of the adhesive layer 30 may be, for example, 10 nm or less, or 8 nm or less, in particular, and the lower limit may be, for example, 1 nm or more, though not limited thereto.

The first silicon substrate may be adhered to the second silicon substrate with the adhesive layer 30. The bonding strength between the first silicon substrate and the second silicon substrate is preferably 1.00 J/$m^2$ or more. Thereby, the bonding strength can be enhanced.

The specific aspect of the method for supplying and bonding the organic material (or composition containing the organic material) may be appropriately selected depending on the organic material for use. Schematically, after supplying the organic material to the first bonding part 13, the first silicon substrate 10 and the second silicon substrate 20 are maintained under specified conditions (at specified temperature, in particular), with the organic material lying between the first bonding part 13 and the second bonding part 23, so that the first bonding part 13 and the second bonding part 23 are

bonded with a reaction product. The organic material may be supplied to the second bonding part 23 instead of the first bonding part 13.

For example, the organic material (or a composition containing the organic material) is applied to the surface of the first silicon substrate 10 on the side of the first bonding part 13, by coating, spraying, printing, or the like. The organic material may be applied directly or in the form of a composition mixed with any suitable component (e.g., solvent). Washing and/or drying may be then performed on an as needed basis. The same washing and drying as described above may be applied, and in the case of using an organic material containing fluorine, pre-washing with a fluorine-based solvent may be performed.

The first silicon substrate 10 and the second silicon substrate 20 are then aligned such that the first bonding part 13 and the second bonding part 23 are faced each other. Thereby, the first silicon substrate 10 is closely contacted to the second silicon substrate 20 through the organic material. The first silicon substrate 10 and the second silicon substrate 20 that are closely contacted to each other are maintained under specific conditions (specific temperature, in particular), so that a reaction proceeds during this period. Then, annealing may be performed on an as needed basis.

For example, in the case where an organic material is applied to the surface of the first bonding part 13, after washing the surface of the layer formed of the organic material with water or water-containing organic solvent, the second bonding part 23 may be disposed on the layer. The organic material may be applied to the surface of the second bonding part 23 instead of the surface of the first bonding part 13.

(Organic materials (i) to (iv))

Exemplary aspects in which the organic materials (i) to (iv) are used are described in the following.

· Usage example of organic material (i)

In this example, as the first silicon substrate 10 and the second silicon substrate 20, one having a hydrosilyl group (-Si-H) on the surface of a first bonding part 13 and a second bonding part 23 (in the present embodiment, a silicon oxide part) may be used. The first silicon substrate 10 and the second silicon substrate 20 that have a hydrosilyl group on the surface of the first bonding part 13 and the second bonding part 23, which are made of silicon oxide, may be obtained, for example, by surface treatment that generates the hydrosilyl group described above.

As the organic material, a substituted or unsubstituted hydrocarbon compound having a plurality of terminal parts and having at least two alkenyl groups is used. The alkenyl group is a reactive group to a hydrosilyl group. Such a compound may have an alkenyl group at any two or more terminal parts. For example, all of the terminal parts may be alkenyl groups. Such a compound may be fluorine-substituted, or in other words, may be a fluoroalkyl compound or a fluoropolyether group-containing compound having an alkenyl group at two or more terminal parts.

For instance, fluoroalkyl compounds having an alkenyl group at 2, 3 or 4 ends are shown in the following. Rf represents a fluoroalkyl group (the same hereinafter). Incidentally, in the following compounds, for example, the alkenyl group may be bonded to a different carbon atom included in Rf.

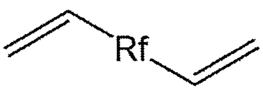 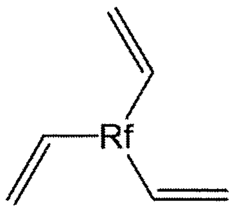 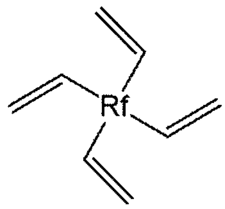

The number of carbons in a part excluding the reactive group at a terminal part (alkenyl group) may be, for example, 1 or more and 200 or less, and 100 or less, in particular, though not limited thereto. The number of carbons may be, for example, 5 or more. The portions excluding the reactive groups may be in a linear, branched or cyclic form. In the case where the portion excluding the reactive groups at terminals is a fluoroalkyl group, which may be, for example, a perfluoroalkyl group without limitations on the fluorine substitution ratio.

The fluoropolyether group-containing compound having an alkenyl group at two or more terminal parts may be, for example, a compound represented by

(A) Formula (1):

$R^D_\gamma$-XA-$R^{F2}$-$X^A$-$R^D_\gamma$ (1)

wherein $R^{F2}$ is $-Rf^2_p-R^F-O_q-$;
$Rf^2$ is a $C_{1-20}$ alkylene group optionally substituted with one or more fluorine atoms;
$R^F$ are each independently groups represented by the following formula at each occurrence:

$$-(OC_6F_{12})_a-(OC_5F_{10})_b-(OC_4F_8)_c-(OC_3R^{Fa}_6)_d-(OC_2F_4)_e-(OCF_2)_f-$$

wherein $R^{Fa}$ are each independently a hydrogen atom, a fluorine atom, or a chlorine atom at each occurrence, a, b, c, d, e and f are each independently an integer of 0 to 200, the sum of a, b, c, d, e and f is 1 or more, and the order of presence of each repeating unit bracketed and subscripted with a, b, c, d, e or f is arbitrary in the formula, provided that in the case all $R^{Fa}$ are hydrogen atoms or chlorine atoms, at least one of a, b, c, e and f is one or more;
p is 0 or 1;
q is 0 or 1;
$R^D$ is $CH_2=CH-$;
$X^A$ are each independently a single bond or a divalent to decavalent organic group;
$\gamma$ are each independently an integer of 1 to 9;

or
(B) Formula (2):

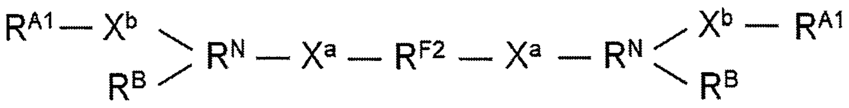
(2)

wherein $R^N$ is:

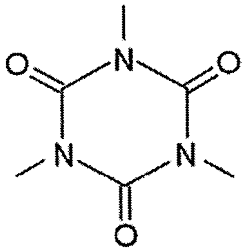
,

or

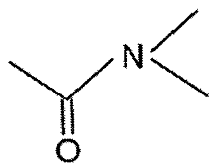

$R^{F2}$ is $-Rf^2_p-R^FO_q-$;
$Rf^2$ is a $C_{1-6}$ alkylene group optionally substituted by one or more fluorine atoms;
$R^F$ are each independently a group represented by the following formula at each occurrence:

$$-(OC6F12)_a-(OC_5F_{10})_b-(OC_4F_8)_c-(OC_3R^{Fa}_6)_d-(OC_2F_4)_e-(OCF_2)_f-$$

wherein $R^{Fa}$ are each independently a hydrogen atom, a fluorine atom, or a chlorine atom at each occurrence, a, b, c, d, e and f are each independently an integer of 0 to 200, the sum of a, b, c, d, e and f is 1 or more, the order of presence of each repeating unit bracketed and subscripted with a, b, c, d, e or f is arbitrary in the formula, and provided that in the case all $R^{Fa}$ are hydrogen atoms or chlorine atoms, at least one of a, b, c, e and f is one or more;
p is 0 or 1;
q is 0 or 1;
$X^a$ are each independently a single bond or a divalent organic group at each occurrence;
$R^{A1}$ are each independently an $OR^{Ac}$ group-containing group at each occurrence;
$R^{Ac}$ is a (meth)acryloyl group;

$R^B$ are each independently $R^{F1}$-$X^a$- or $R^{A1}$-$X^b$- at each occurrence;
$R^{F1}$ is $Rf^1$-$R^F$-$O_q$-;
$Rf^1$ is a $C_{1-16}$ alkyl group optionally substituted by one or more fluorine atoms, and
$X^b$ is a divalent organic group. In the left formula of $R^N$, it may be that any of the linking groups bonds to $X^a$, and in the right formula, the left side bonds to $X^a$ and the right side bonds to $X^b$ or $R^B$. Further, in $R^F$, the sum of a, b, c, d, e and f may be, for example, 5 or more.

The organic material is supplied between the first bonding part 13 and the second bonding part 23, so that a reaction between the alkenyl groups of the organic material and the hydrosilyl groups of the first bonding part 13 and the second bonding part 23 are caused (hydrosilylation). Thereby, the reaction product derived from the organic material chemically bonds to the Si atoms of the first bonding part 13 and the Si atoms of the second bonding part 23, so that the first bonding part 13 and the second bonding part 23 are bonded with the reaction product derived from the organic material. According to the reaction, no by-product is generated, so that the problem of formation of voids derived from by-products can be fundamentally eliminated.

The reaction may be performed once with the organic material sandwiched between the first bonding part 13 and the second bonding part 23, or may be performed in two separate times by applying the organic material on any one of the first bonding part 13 and the second bonding part 23 for partial proceeding of the reaction, and then disposing another one on top of the organic material for further proceeding of the reaction.

An exemplary reaction with use of a fluoroalkyl compound having alkenyl groups at two terminal parts is shown as follows. (The same applies to a fluoropolyether group-containing compound having alkenyl groups at two terminal parts.)

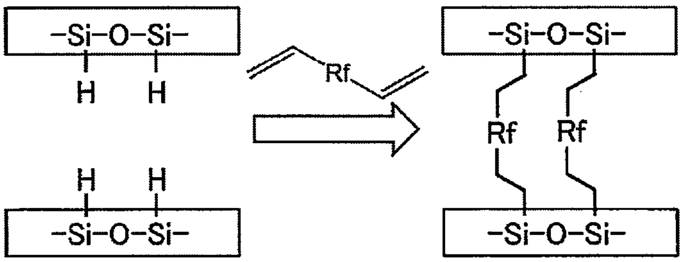

It is preferable that the reaction product derived from the organic material chemically bond to both the Si atoms of the first bonding part 13 and the Si atoms of the second bonding part 23. However, it is not required that all the reaction products bond to both the Si atoms of the first bonding part 13 and the Si atoms of the second bonding part 23. A part of the reaction products may chemically bond to any of the Si atoms of the first bonding part 13 and the Si atoms of the second bonding part 23 only, or may chemically bond to two or more Si atoms in the same silicon substrate. In order to achieve higher bonding strength, it is preferable that a larger number of reaction products chemically bond to both of the Si atom of the first bonding part 13 and the Si atom of the second bonding part 23. From the viewpoint, it is preferable that the organic material be a straight-chain compound having an alkenyl group at both terminal parts, though not limited thereto.

· Example with use of organic material (ii)

In this example, as the first silicon substrate 10, one having a silanol group (-Si-OH) on the surface of the first bonding part 13 (silicon oxide part in the present embodiment) is used. The first silicon substrate 10 having silanol groups on the surface of the first bonding part 13 as silicon oxide portion requires no particular surface treatment, though the silanol groups may be obtained by the surface treatment to produce silanol groups described above on an as needed basis.

Preferably, as the second silicon substrate 20, one having a hydrosilyl group (-Si-H) on the surface of the second bonding part 23 (silicon oxide part in the present embodiment) is used. The second silicon substrate 20 having a hydrosilyl group on the surface of the second bonding part 23 as silicon oxide part may be obtained by the surface treatment that generates hydrosilyl groups described above.

As the organic material, a substituted or unsubstituted hydrocarbon compound having a plurality of terminal groups, with an alkenyl group at at least one terminal part, and a hydroxyl group at at least one terminal part is used. Specifically, a substituted or unsubstituted hydrocarbon compound having an alkenyl group at one terminal part and a hydroxyl group at another terminal end is used. The alkenyl group is a reactive group to the hydrosilyl group, and the hydroxyl group is a reactive group to the silanol group. Such a compound may have two or more terminal parts and may have an alkenyl group at any one or more terminal parts and a hydroxyl group at any one or more terminal parts. Such a compound may be fluorine-substituted, or in other words, may be a fluoroalkyl compound or a fluoropolyether group-containing compound having an alkenyl group at one terminal part and a hydroxyl group at the other terminal part.

In addition, unless otherwise specified, the explanations described above may apply. (The same applies as described for the fluoroalkyl compound or fluoropolyether group-containing compound in detail in the (i), except for having a hydroxyl group at least at one terminal.)

The organic material is supplied between the first bonding part 13 and the second bonding part 23 to cause a reaction between the hydroxyl group of the organic material and the silanol group of the first bonding part 13 (etherification by dehydration) and a reaction between the alkenyl group of the organic material and the hydrosilyl group of the second bonding part 23 (hydrosilylation). Thereby, the reaction product derived from the organic material is chemically bound to the Si atoms of the first bonding part 13 and the Si atoms of the second bonding part 23, so that the first bonding part 13 and the second bonding part 23 are bonded by the reaction product derived from the organic material.

More specifically, it is preferable that the organic material be supplied to the first bonding part 13 to cause a reaction between the hydroxyl groups of the organic material and the silanol groups of the first bonding part 13 (first stage), and then the first bonding part 13 and the second bonding part 23 be disposed facing each other to cause a reaction between the alkenyl groups of the organic material and the hydrosilyl groups of the second bonding part 23 (second stage). According to the procedure, water produced as a by-product in the reaction in the first stage can be removed without being trapped between the first bonding part 13 and the second bonding part 23, and since no by-products are generated in the second-stage reaction, formation of voids derived from the by-products can be avoided.

An exemplary reaction with use of a fluoroalkyl compound having an alkenyl group at one terminal part and a hydroxyl group at the other terminal part is shown in the following. (The case of a fluoropolyether group-containing compound having an alkenyl group at one terminal part and a hydroxyl group at the other terminal part is also in the same manner as follows.)

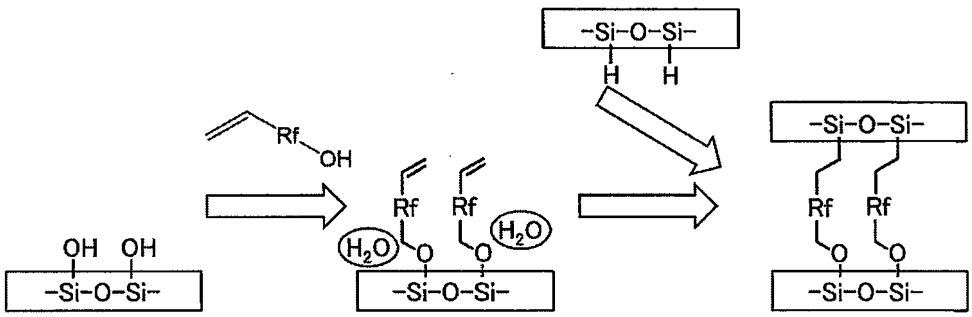

In order to obtain higher bonding strength, the organic material is preferably a linear compound having an alkenyl group and a hydroxyl group at both terminal parts, respectively, though not limited thereto.

Further, according to this example, one having silanol groups in the surface of the first bonding part 13 is used as the first silicon substrate 10, and one having hydrosilyl groups in the surface of the second bonding part 23 is used as the second silicon substrate 20. Accordingly, in the case of using an organic material having an alkenyl group and a hydroxy group at both terminal parts, respectively (preferably in a straight chain form), chemical bonding of the reaction product to two or more Si atoms in the same silicon substrate can be avoided, so that further higher bonding strength can be achieved.

Use of a substituted or unsubstituted hydrocarbon compound having an alkenyl group at one terminal part and a hydroxyl group at the other terminal part as the organic material has been described as an example however, instead of/in addition to the hydroxyl group, a substituted or unsubstituted hydrocarbon compound having a hydrolyzable silyl group, an isocyanate group, an epoxy group, an amino group or an acid anhydride group may be used. Any of a hydroxyl group, a hydrolyzable silyl group, an isocyanate group, an epoxy group, an amino group and an acid anhydride group can function as a reactive group for the silanol group. (The substituted or unsubstituted hydrocarbon compound having an alkenyl group at one terminal part and a hydroxyl group at the other terminal part may be the same as a substituted or unsubstituted hydrocarbon compound having hydrolyzable silyl groups at two terminal parts to be described in detail in the following (iii), except for having an alkenyl group at least at one terminal.)

· First example with use of organic material (iii)

In this example, as the first silicon substrate 10 and the second silicon substrate 20, one having silanol groups (-Si-OH) on the surfaces of the first bonding part 13 and the second bonding part 23 (silicon oxide portion in the present embodiment) is used. The first silicon substrate 10 and the second silicon substrate 20 having silanol groups on the surfaces of the first bonding part 13 and the second bonding part 23 as silicon oxide portions require no particular surface treatment, or may be obtained by the surface treatment to produce silanol groups described above on an as needed basis.

As the organic material, a substituted or unsubstituted hydrocarbon compound having a plurality of terminal parts

and having a hydrolyzable silyl group at at least two terminal parts is used. Specifically, a substituted or unsubstituted hydrocarbon compound having a hydrolyzable silyl group at two terminal ends is used. Such a compound may have two or more terminal parts and may have a hydrolyzable silyl group at any two or more terminal parts. Such a compound may be fluorine-substituted, or in other words, may be a fluorine-containing silane compound such as a fluoroalkyl compound or a fluoropolyether group-containing compound having a hydrolyzable silyl group at two terminal parts.

The fluorine-containing silane compound may be, for example, a compound represented by the following formula (11):

$$R^{Si}_{\gamma}\text{-}X^{A}\text{-}R^{F2}\text{-}X^{A}\text{-}R^{Si}_{\gamma} \qquad (11)$$

wherein:

$R^{F2}$ is $-Rf^2_p-R^F_r-O_q-$;
$Rf^2$ is a $C_{1-20}$ alkylene group optionally substituted by one or more fluorine atoms;
$R^F$ are each independently a group represented by the following formula at each occurrence:

$$-(OC_6F_{12})_a-(OC_5F_{10})_b-(OC_4F_8)_c-(OC_3R^{Fa}{}_6)_d-(OC_2F_4)_e-(OCF_2)_f-$$

wherein $R^{Fa}$ are each independently a hydrogen atom, a fluorine atom, or a chlorine atom at each occurrence,
a, b, c, d, e and f are each independently an integer of 0 to 200, the sum of a, b, c, d, e and f is 1 or more; the order of presence of each repeating unit bracketed and subscripted with a, b, c, d, e or f is arbitrary in the formula, and provided that in the case all $R^{Fa}$ are hydrogen atoms or chlorine atoms, at least one of a, b, c, e and f is one or more;
p is 0 or 1;
q is 0 or 1;
r is 0 or 1;
provided that any one of p or r is 1;
$R^{Si}$ is each independently a group represented by the following formulas (S1), (S2), (S3), (S4) or (S5) at each occurrence:

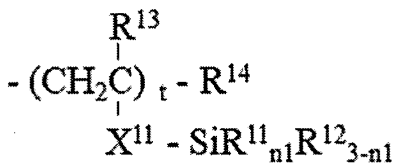
(S1)

$$-SiR^{11}_{n1}R^{12}_{3-n1} \qquad (S2)$$

$$-SiR^{a1}_{k1}R^{b1}_{l1}R^{c1}_{m1} \qquad (S3)$$

$$-CR^{d1}_{k2}R^{e1}_{l2}R^{f1}_{m2} \qquad (S4)$$

$$-NR^{g1}R^{h1} \qquad (S5)$$

wherein:

$R^{11}$ is each independently a hydroxyl group or a hydrolyzable group at each occurrence;
$R^{12}$ is each independently a hydrogen atom or a monovalent organic group at each occurrence;
n1 is each independently an integer of 0 to 3 for each $(SiR^{11}_{n1}R^{12}_{3-n1})$ unit;
$X^{11}$ is each independently a single bond or a divalent organic group at each occurrence;
$R^{13}$ is each independently a hydrogen atom or a monovalent organic group at each occurrence;
t is each independently an integer of 2 or more at each occurrence;
$R^{14}$ is each independently a hydrogen atom, a halogen atom or $-X^{11}-SiR^{11}_{n1}R^{12}_{3-n1}$ at each occurrence;
$R^{a1}$ is each independently $-Z^1-SiR^{21}_{p1}R^{22}_{q1}R^{23}_{r1}$ at each occurrence;
$Z^1$ is each independently an oxygen atom or a divalent organic group at each occurrence;
$R^{21}$ is each independently $-Z^{1'}-SiR^{21'}_{p1'}R^{22'}_{q1'}R^{23'}_{r1'}$ at each occurrence;
$R^{22}$ is each independently a hydroxyl group or a hydrolyzable group at each occurrence;

$R^{23}$ is each independently a hydrogen atom or a monovalent organic group at each occurrence;
p1 is each independently an integer of 0 to 3 at each occurrence;
q1 is each independently an integer of 0 to 3 at each occurrence;
r1 is each independently an integer of 0 to 3 at each occurrence;
$Z^{1'}$ is each independently an oxygen atom or a divalent organic group at each occurrence;
$R^{21'}$ is each independently $-Z^{1''}-SiR^{22''}{}_{q1''}R^{23''}{}_{r1''}$ at each occurrence;
$R^{22'}$ is each independently a hydroxyl group or a hydrolyzable group at each occurrence;
$R^{23'}$ is each independently a hydrogen atom or a monovalent organic group at each occurrence;
p1' is each independently an integer of 0 to 3 at each occurrence;
q1' is each independently an integer of 0 to 3 at each occurrence;
r1' is each independently an integer of 0 to 3 at each occurrence;
$Z^{1''}$ is each independently an oxygen atom or a divalent organic group at each occurrence;
$R^{22''}$ is each independently a hydroxyl group or a hydrolyzable group at each occurrence;
$R^{23''}$ is each independently a hydrogen atom or a monovalent organic group at each occurrence;
q1" is each independently an integer of 0 to 3 at each occurrence;
r1" is each independently an integer of 0 to 3 at each occurrence;
$R^{b1}$ is each independently a hydroxyl group or a hydrolyzable group at each occurrence;
$R^{c1}$ is each independently a hydrogen atom or a monovalent organic group at each occurrence;
k1 is each independently an integer of 1 to 3 at each occurrence;
l1 is each independently an integer of 0 to 3 at each occurrence;
m1 is each independently an integer of 0 to 3 at each occurrence;
$R^{d1}$ is each independently $-Z^2-CR^{31}{}_{p2}R^{32}{}_{q2}R^{33}{}_{r2}$ at each occurrence;
$Z^2$ is each independently a single bond, an oxygen atom or a divalent organic group at each occurrence;
$R^{31}$ is each independently $-Z^{2'}-CR^{32'}{}_{q2'}R^{33'}{}_{r2'}$ at each occurrence;
$R^{32}$ is each independently $-Z^3-SiR^{34}{}_{n2}R^{35}{}_{3-n2}$ at each occurrence;
$R^{33}$ is each independently a hydrogen atom, a hydroxyl group, or a monovalent organic group at each occurrence;
p2 is each independently an integer of 0 to 3 at each occurrence;
q2 is each independently an integer of 0 to 3 at each occurrence;
r2 is each independently an integer of 0 to 3 at each occurrence;
$Z^{2'}$ is each independently a single bond, an oxygen atom or a divalent organic group at each occurrence;
$R^{32'}$ is each independently $-Z^3-SiR^{34}{}_{n2}R^{35}{}_{3-n2}$ at each occurrence;
$R^{33'}$ is each independently a hydrogen atom, a hydroxyl group, or a monovalent organic group at each occurrence;
q2' is each independently an integer of 0 to 3 at each occurrence;
r2' is each independently an integer of 0 to 3 at each occurrence;
$Z^3$ is each independently a single bond, an oxygen atom or a divalent organic group at each occurrence;
$R^{34}$ is each independently a hydroxyl group or a hydrolyzable group at each occurrence;
$R^{35}$ is each independently a hydrogen atom or a monovalent organic group at each occurrence;
n2 is each independently an integer of 0 to 3 at each occurrence;
$R^{e1}$ is each independently $-Z^3-SiR^{34}{}_{n2}R^{35}{}_{3-n2}$ at each occurrence;
$R^{f1}$ is each independently a hydrogen atom, a hydroxyl group, or a monovalent organic group at each occurrence;
k2 is each independently an integer of 0 to 3 at each occurrence;
l2 is each independently an integer of 0 to 3 at each occurrence;
m2 is each independently an integer of 0 to 3 at each occurrence;
$R^{g1}$ is $R^{h1}$ are each independently $-Z^4-SiR^{11}{}_{n1}R^{12}{}_{3-n1}$, $-Z^4-SiR^{a1}{}_{k1}R^{b1}{}_{l1}R^{c1}{}_{m1}$, or $-Z^4-CR^{d1}{}_{k2}R^{e1}{}_{l2}R^{f1}{}_{m2}$ at each occurrence;
$Z^4$ is each independently a single bond, an oxygen atom or a divalent organic group at each occurrence;
provided that, in formulas (S1), (S2), (S3), (S4) and (S5), at least one Si atom binding to a hydroxyl group or hydrolyzable group is present;
$X^A$ is each independently a single bond or a divalent to decavalent organic group; and
$\gamma$ is each independently an integer of 1 to 9.

The hydrolyzable group means a group that can be subjected to a hydrolysis reaction, preferably $-OR^j$, $-OCOR^j$, $-O-N=CR^j{}_2$, $-NR^j{}_2$, $-NHR^j$ or a halogen. $R^j$ is a substituted or unsubstituted $C_{1-4}$ alkyl group, preferably an unsubstituted $C_{1-4}$ alkyl group. The $C_{1-4}$ alkyl group is preferably an ethyl group or a methyl group, more preferably a methyl group.

The simplest hydrolyzable silyl group may be an alkoxysilyl group. The number of alkoxy group in the alkoxysilyl group is 1 or more and 3 or less, and may be, for example, 3. The number of carbon atoms in the alkoxy group may be, for example, 1 or more and 4 or less, particularly 2 or less, and preferably 1.

The unsubstituted silane compound may be, for example, a compound represented by $R^k{}_3Si-(CH_2)_{n35}-SiR^k{}_3$. $R^k$

each independently mean a group that may be subjected to a hydrolysis reaction, and preferably each independently are $-OR^j$, $-OCOR^j$, $-O-N=CR^j_2$, $-NR^j_2$, $-NHR^j$ or a halogen. $R^j$ is a substituted or unsubstituted $C_{1-4}$ alkyl group, preferably an unsubstituted $C_{1-4}$ alkyl group. The $C_{1-4}$ alkyl group is preferably an ethyl group or a methyl group, more preferably a methyl group. Further, n35 is an integer of 1 to 18.

Unless otherwise specified, the above explanation may be applied.

The organic material is supplied between the first bonding part 13 and the second bonding part 23, so that the hydrolyzable silyl groups of the organic material react with the silanol groups of the first bonding part 13 and the second bonding part 23 (for example, in the case where the hydrolyzable group is an alkoxy group, formation of siloxane bonds due to dealcoholization). Thereby, the reaction product derived from the organic material chemically bonds to the Si atoms of the first bonding part 13 and the Si atoms of the second bonding part 23, so that the first bonding part 13 and the second bonding part 23 are bonded with the reaction product derived from the organic material. The alcohol has only a small number of carbon atoms as described above, and can be removed to the outside effectively through openings of the reaction product between the first bonding part 13 and the second bonding part 23, so that the formation of voids derived from by-products can be reduced.

It is preferable that the organic material be applied to any of the first bonding part 13 and the second bonding part 23 to cause a reaction with the first bonding part 13 or the second bonding part 23, and after subsequent washing of the surface of the layer formed from the organic material with water or water-containing organic solvent, the other one be disposed on the layer. Thereby, the hydrolyzable silyl groups present on the surface are transformed into silanol, so that the formation of voids derived from by-products such as alcohols resulting from hydrolysis can be further suppressed.

The reaction may be performed once with the organic material sandwiched between the first bonding part 13 and the second bonding part 23, or may be performed in two separate times by applying the organic material on any one of the first bonding part 13 and the second bonding part 23 for partial proceeding of the reaction, and then disposing another one on top of the organic material for further proceeding of the reaction.

An exemplary reaction with use of an alkyl compound having a trimethoxysilyl group at two terminal parts is shown as follows. (In the following, an exemplary reaction performed in two separate times as described above is also shown.)

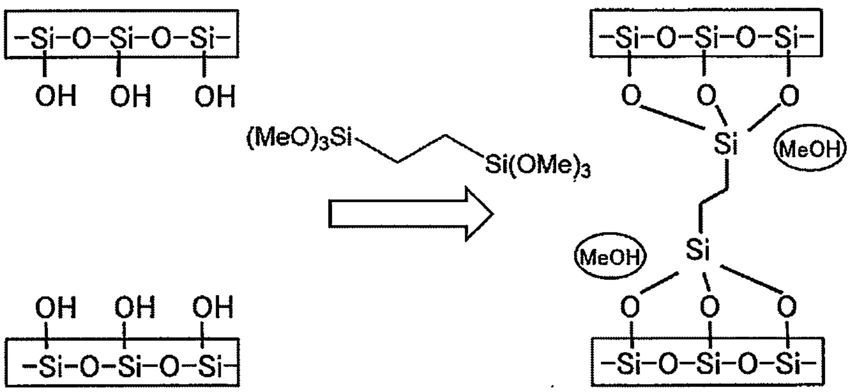

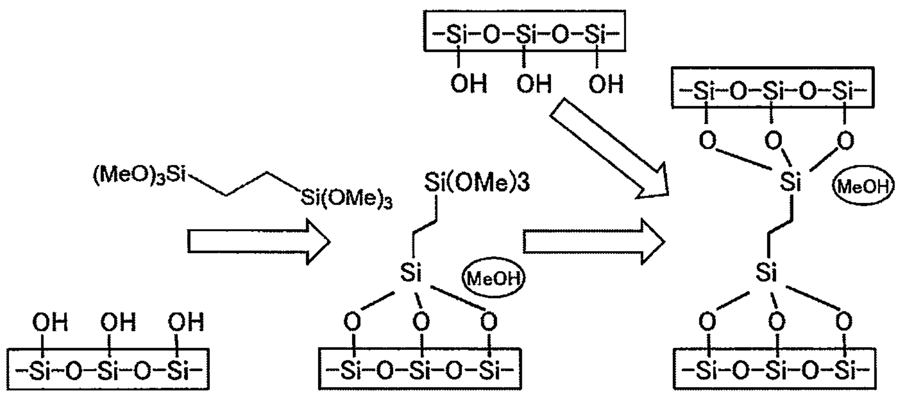

In order to obtain higher bonding strength, the organic material is preferably a linear compound having a hydrolyzable silyl group at both terminal parts, though not limited thereto.

· Second example using organic material (iii)

In the example, differences from the first example using the organic material (iii) described above will be mainly explained, and unless otherwise specified, the explanations described in the first example may be applied.

As the organic material, a substituted or unsubstituted hydrocarbon compound having an isocyanate group at two terminal parts is used. The compound may have two or more terminal parts, and may have an isocyanate group at any two or more terminal parts.

The organic material is supplied between the first bonding part and the second bonding part, such that an isocyanate group of the organic material reacts with the silanol group of the first bonding part and the second bonding part (formation of urethane bond). Thereby, the reaction product derived from the organic material is chemically bound to the Si atoms of the first bonding part and the Si atoms of the second bonding part, so that the first bonding part and the second bonding part are bonded by the reaction product derived from the organic material. According to the reaction, no by-products are generated, so that the problem of formation of voids derived from by-products can be fundamentally eliminated.

The unsubstituted silane compound may be, for example, a compound represented by $OCN-(CH_2)_{n35}-NCO$. Incidentally, n35 is an integer of 1 to 18.

As an example, a reaction in the case of using an alkyl compound having an isocyanate group at two terminal parts is shown as follows.

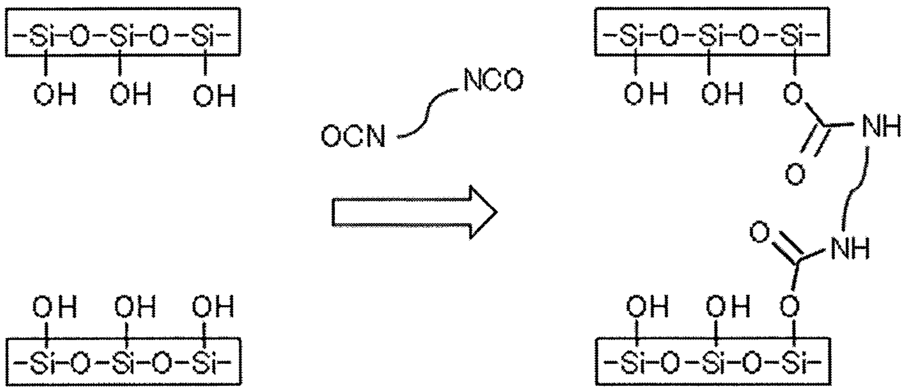

· Third example using organic material (iii)

In the example, differences from the first example using the organic material (iii) described above will be mainly explained, and unless otherwise specified, the explanations described in the first example may be applied.

As the organic material, a substituted or unsubstituted hydrocarbon compound having a phosphate group is used. The compound may have two or more terminal parts, and may have a phosphate group at any two or more terminal parts.

In the following, although $CH_3PO(OH)_2$ is used as an example of the compound having a phosphate group, in the present aspect, other compounds having another structure may be used as long as having a phosphate group. For example, a compound having two or more phosphate groups such as 1,6-hexane diphosphonate may be used. In the case of a compound having two or more phosphate groups, one of the phosphate groups may react with the first bonding part 13 and another phosphate group may react with the second bonding part 23.

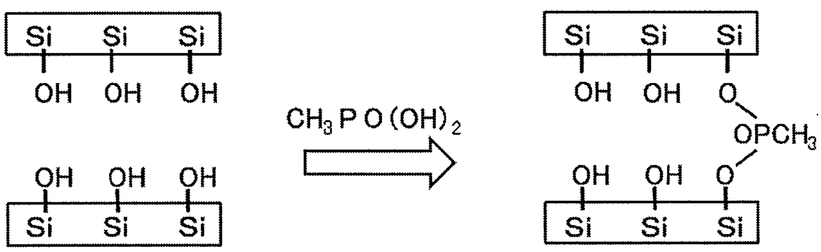


· Fourth example using organic material (iii)

In the example, differences from the first example using the organic material (iii) described above will be mainly

explained, and unless otherwise specified, the explanations described in the first example may be applied.

As the organic material, a substituted or unsubstituted hydrocarbon compound having an acid anhydride group at two terminal parts is used. The compound may have two or more terminal parts, and may have an acid anhydride group at any two or more terminal parts.

The organic material is supplied between the first bonding part 13 and the second bonding part 23, such that the acid anhydride group of the organic material reacts with the silanol group in the first bonding part 13 and second bonding part 23. Thereby, the reaction product derived from the organic material chemically bonds to the Si atoms of the first bonding part 13 and the Si atoms of the second bonding part 23, so that the first bonding part 13 and the second bonding part 23 are bonded by the reaction product derived from the organic material. According to the reaction, no by-products are generated, so that the problem of formation of voids derived from by-products can be fundamentally eliminated.

As an example, a reaction with use of an alkyl compound having an anhydride group at two terminal parts is shown in the following.

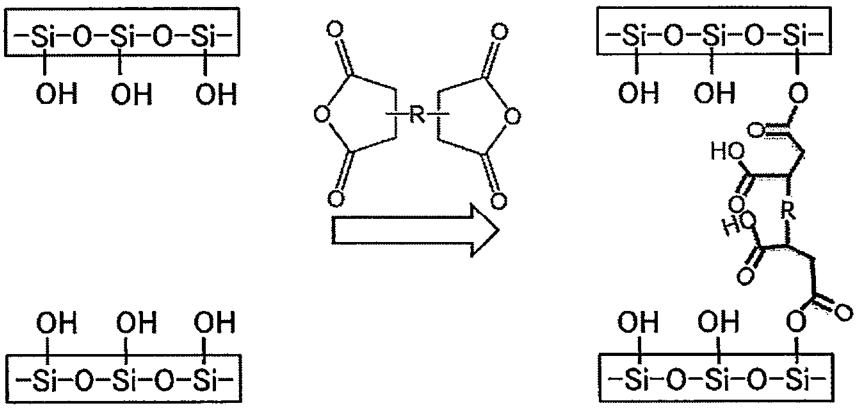

R represents an alkyl group, which is shown, for example, by $-(CH_2)_{n36}-$. Incidentally, n36 is an integer of 1 to 18.

In the above, the first to third examples with use of a substituted or unsubstituted hydrocarbon compound having a hydrolyzable silyl group, an isocyanate group, or an acid anhydride group at two terminal parts as the organic material have been described; however, instead of/in addition to a hydrolyzable silyl group, an isocyanate group, or an acid anhydride group, a substituted or unsubstituted hydrocarbon compound having a hydroxyl group, an epoxy group and/or an amino group may be used. Any of the hydroxyl group, hydrolyzable silyl group, isocyanate group, epoxy group, amino group and acid anhydride group can function as a reactive group for silanol groups. These reactive groups on at least two terminal parts may be the same or different.

· Example using organic material (iv)

In the example, differences from the first example using the organic material (iii) described above will be mainly explained, and unless otherwise specified, the explanations described in the first example may be applied.

As the organic material, silsesquioxane is used. Silsesquioxane means a silicon-containing polymer having a main chain composed of siloxane bonds (polysiloxane) with a T unit as fundamental structural unit. Silsesquioxane can be represented by a composition formula $(R'SiO_{1.5})_n$ (R' may be any organic group and n is 6 or more), and may have a random structure, a ladder structure, a cage structure (complete cage structure and incomplete cage structure) or the like. Examples of the hydrocarbon group R' include an acyclic or cyclic aliphatic hydrocarbon group such as methyl, ethyl, propyl (n-propyl, i-propyl), butyl (n-butyl, i-butyl, t-butyl, sec-butyl), pentyl (n-pentyl, i-pentyl, neopentyl, cyclopentyl, etc.), hexyl (n-hexyl, i-hexyl, cyclohexyl, etc.), heptyl (n-heptyl, i-heptyl, etc.), octyl (n-octyl, i-octyl, t-octyl, etc.), nonyl (n-nonyl, i-nonyl, etc.), decyl (n-decyl, i-decyl, etc.), undecyl (n-undecyl, i-undecyl, etc.), and dodecyl (n-dodecyl, i-dodecyl, etc.), an acyclic and cyclic alkenyl group such as vinyl, propenyl, butenyl, pentenyl, hexenyl, cyclohexenyl, cyclohexenylethyl, norbornenylethyl, heptenyl, octenyl, nonenyl, decenyl, undecenyl, dodecenyl, and styrenyl, an aralkyl group such as benzyl, phenethyl, 2-methylbenzyl, 3-methylbenzyl, and 4-methylbenzyl, an aralkenyl group such as PhCH=CH- group, an aryl group such as phenyl group, tolyl group, or xylyl group, and a substituted aryl group such as 4-aminophenyl group, 4-hydroxyphenyl group, 4-methoxyphenyl group, and 4-vinylphenyl group.

The organic material is supplied on a first bonding part 13, such that the siloxane bond part of the organic material reacts with the silanol group in the first bonding part 13 (cleavage addition of siloxane bond). Then, a second bonding part 23 is provided on the organic material on the opposite side of the first bonding part to cause a reaction between the siloxane bond part of the organic material and the silanol group of the second bonding part 23 (cleavage addition of siloxane bond).

Thereby, the reaction product derived from the organic material is chemically bound to the Si atoms of the first bonding part 13 and the Si atoms of the second bonding part 23, so that the first bonding part 13 and the second bonding part 23 are bonded by the reaction product derived from the organic material. According to the reaction, no by-products are generated, so that the problem of formation of voids derived from by-products can be fundamentally eliminated. Alternatively, the organic material may be supplied between the first bonding part 13 and the second bonding part 23 to cause a reaction between the siloxane bond part of the organic material and the silanol groups of the first bonding part 13 and the second bonding part 23 (cleavage addition of siloxane bond).

An exemplary reaction with use of $T_8$ silsesquioxane ($(R'SiO_{1.5})_8$) having a complete cage structure is shown in the following.

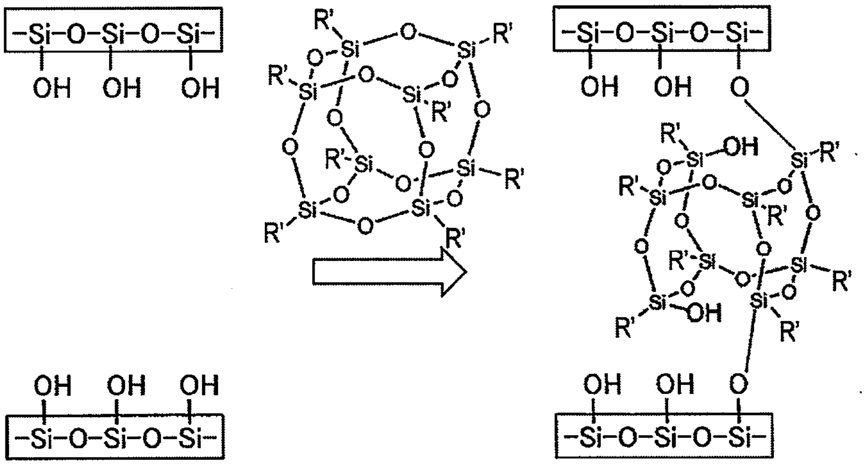

In order to obtain higher bonding strength, it is preferable that the organic material be a cage-type silsesquioxane having a definite molecular structure, though not limited thereto.

The example with use of silsesquioxane as the organic material has been described in the above; however, a derivative of silsesquioxane may be also used. The derivative of silsesquioxane may be a compound derived from silsesquioxane, and may have any substituent, modifying group, functional group, or the like.

(Reaction condition)

· Organic material

The reaction conditions may vary depending on the organic material used. The reaction temperature may be, for example, 200°C or less, particularly 120°C or less, more particularly 80°C or less, and conveniently normal temperature (typically 10°C or more and 40°C or less). According to the present embodiment, bonding can be performed at such relatively low temperature, so that highly accurate bonding of the first bonding part 13 and the second bonding part 23 can be achieved with a reduced displacement caused by thermal expansion of the silicon substrates. The pressure (absolute pressure, also the same for other pressure values in the present specification) is, for example, $10^{-8}$ Pa or more, particularly $10^{-5}$ Pa or more, more particularly $10^{-1}$ Pa or more, and still more particularly $10^2$ Pa or more, and conveniently normal pressure (typically about $1.01\times10^5$ Pa). In the case where a reduced pressure is applied, the pressure may be, for example, $10^5$ Pa or less, particularly $10^4$ Pa or less, more particularly $10^3$ Pa or less.

· Inorganic material

The specific aspect of the method for supplying and bonding the inorganic material (or composition including inorganic material) may be appropriately selected depending on the inorganic material for use. Schematically, the inorganic material is supplied to the first bonding part 13, and then in a state with the inorganic material lying between the first bonding part 13 and the second bonding part 23, the first silicon substrate 10 and the second silicon substrate 20 are maintained under specified reaction conditions (at specified temperature, in particular), so that the first bonding part 13 and the second bonding part 23 are bonded with the reaction product. Alternatively, the inorganic material may be supplied to the second bonding part 23, instead of the first bonding part.

For example, the inorganic material (or a composition containing the inorganic material) is applied to the surface of the first silicon substrate 10 on the side of the first bonding part 13 by spin coating, vapor deposition, or the like. The inorganic material may be applied in an intact state, or in a state mixed with any appropriate component (for example,

solvent). Then, on an as needed basis, washing and/or drying may be performed. On an as needed basis, preliminary washing may be performed.

The first silicon substrate 10 and the second silicon substrate 20 are then aligned such that the first bonding part 13 and the second bonding part 23 are faced each other. Thereby, the first silicon substrate 10 is closely contacted to the second silicon substrate 20, with the inorganic material lying between the first bonding part 13 and the second bonding part 23. The first silicon substrate 10 and the second silicon substrate 20 in a close contact state are maintained under specified reaction conditions on an as needed basis (at specified temperature, in particular) to be bonded. The inorganic material may be bonded to the first silicon substrate 10 and the second silicon substrate 20 without reaction, or at least a part thereof may cause a reaction.

By the production method, a layered product 40 having a first silicon substrate 10, a second silicon substrate 20, and an adhesive layer 30 between the first silicon substrate 10 and the second silicon substrate 20, is formed. In other words, the layered product 40 includes:

a first silicon substrate 10 having a first bonding part 13;
a second silicon substrate 20 having a second bonding part 23, located on the side of the first bonding part 13; and
an adhesive layer 30 that is located between the first bonding part 13 and the second bonding part 23 and that allows the first bonding part 13 and the second bonding part 23 to adhere to each other;
wherein the first bonding part 13 and the second bonding part 23 have a hydrosilyl group and/or a silanol group derived from silicon oxide, or a region bonding to an inorganic material;
the adhesive layer 30 includes a reaction product of a reaction with the hydrosilyl group and/or the silanol group, or a region bonding to the inorganic material;
the number of clusters of particles on the surface of the adhesive layer 30 is 5 pieces/$cm^2$ or less; and
the bonding strength between the first silicon substrate 10 and the second silicon substrate 20 is 1.00 J/$m^2$ or more.

The surface of the adhesive layer 30 means a cured product on the surface of the adhesive layer 30 disposed on the first silicon substrate 10.

In the layered product 40, the adhesive layer 30 may include an organic substance generated during formation of the adhesive layer 30. The organic substance may be presumed to be a residue of organic material reactable with a hydrosilyl group and/or a silanol group.

The organic substance may chemically bond to the Si atoms of the first bonding part 13 and the Si atoms of the second bonding part 23.

The inorganic substance may bond to the first bonding part 13 and the second bonding part 23. In this case, the inorganic substance may bond to the first bonding part 13 and the second bonding part 23 without reaction, or with a reaction at at least a part. In this case, in the layered product 40, the adhesive layer 30 may include an inorganic substance generated during formation of the adhesive layer 30. The inorganic substance may be presumed to be a residue of inorganic substance resulting from the reaction with the first silicon substrate and the second silicon substrate.

The upper limit of the bonding strength may be, for example, 2.5 J/$m^2$ or less, though not limited thereto.

<Second embodiment>

Figure 2 is a schematic cross-sectional diagram showing a part of a layered product 40A in a second embodiment. In the first embodiment, an adhesive layer 30 is present between the first bonding part 13 and the second bonding part 23. The second embodiment is different in that a first adhesive part 31A and a second adhesive part 32A are included, wherein the first adhesive part 31A is present on the first bonding part 13, and the second adhesive part 32A is present on the second bonding part 23. The following description focuses on the different points, and unless otherwise specified, regarding other points, the structure is the same as in the first embodiment.

(Adhesive layer 30A)

As shown in Figure 2, the adhesive layer 30A has a first adhesive part 31A and a second adhesive part 32A that is disposed on the second bonding part 23 and bonded to the first adhesive part 31A. The first adhesive part 31A and the second adhesive part 32A are bonded through a reaction. In the chemical bonding reaction, heating and/or increasing or decreasing pressure are performed on an as needed basis. The conditions for heating and increasing or decreasing pressure are the same as in the first embodiment. The physical properties and constituent materials of the adhesive layer 30A are similar to those of the adhesive layer 30 in the first embodiment.

In an aspect, the first adhesive part 31A may be obtained by coating a first organic material reactable with the first bonding part 13 to the first bonding part 13, and then drying the resultant. The second adhesive part 32A may be obtained by coating a second organic material reactable with the second bonding part 23 to the second bonding part 23, and then

drying the resultant. The drying may be performed in the same manner as in the first embodiment.

In another aspect, the first adhesive part 31A may be obtained by supplying a first inorganic material on the first bonding part 13, and then drying the material on an as needed basis. The second adhesive part 32A may be obtained by supplying a second inorganic material on the second bonding part 23, and then drying the material. The drying may be performed in the same manner as in the first embodiment.

The first adhesive part 31A and the second adhesive part 32A described for convenience may have no boundary surface or may be mixed. In the case where a boundary surface is formed, the boundary surface may not be a uniform surface, or may be uneven.

The number of clusters of particles contained in the surface of the first adhesive part 31A on the opposite side of the first bonding part 13 is 5 pieces/$cm^2$ or less. The numbers of particles and clusters in the present embodiment are as defined in the first embodiment.

Preferably, the number of clusters of particles contained in the surface of the second adhesive part 32A on the opposite side of the second bonding part 23 is 5 pieces/$cm^2$ or less. The lower limit of the number of clusters is, for example, 1 piece/$cm^2$ or more, specifically, 0 piece/$cm^2$ or more, though not limited thereto.

The second adhesive part 32A may include 2 or more layers. In other words, the second adhesive part 32A as a first layer may be disposed on the second bonding part 23, which is dried and/or heated on an as needed basis, and then the second adhesive part 32A as a second layer may be disposed. The number of layers of the second adhesive part 32A may be, for example, three or less, though not limited thereto.

(First and second organic materials)

The first organic material has a functional group reactable with the first bonding part 13 at one terminal part, and a functional group reactable with the second organic material at the other terminal part. The second organic material has a functional group reactable with the second bonding part 23 at one terminal part, and a functional group reactable with the first organic material at the other terminal part. Thereby, the first silicon substrate 10 is bonded to the second silicon substrate 20. It may be that only a part of the functional group is reactable. Although the case where one organic material has two functional groups is described above, the organic material may have three or more functional groups.

Each of the first organic material and the second organic material may be contained in a composition for use. The composition has the same structure as in the first embodiment.

The specific aspects of the methods for supplying and bonding the first and second organic materials (or a composition containing the first and second organic materials) may be appropriately selected depending on the organic material for use. Schematically, after supplying the first and second organic materials, in a state with the first and second organic materials lying between the first silicon substrate 10 and the second silicon substrate 20, the first silicon substrate 10 and the second silicon substrate 20 are maintained under specified reaction conditions (at specified temperature, in particular), such that the reaction proceeds.

More specifically, for example, the first organic material (which may be a composition) is applied to the first bonding part 13 of the first silicon substrate 10, by coating, spraying, printing, or the like. In the same manner, the second organic material (which may be a composition) is applied to the second bonding part 23 of the second silicon substrate 20. Then, washing and/or drying may be performed on an as needed basis. In the washing and drying, the same described above may be applied. In the case of using an organic material containing fluorine, pre-washing with use of a fluorine-based solvent may be performed.

Then, the first silicon substrate 10 and the second silicon substrate 20 are aligned such that the first bonding part 13 faces to the second bonding part 23. Thereby, the first silicon substrate 10 comes into close contact with the second silicon substrate 20 with the first and second organic materials lying between the first bonding part 13 and the second bonding part 23. The first silicon substrate 10 and the second silicon substrate 20 that are in close contact are maintained under specified conditions (at specified temperature, in particular) such that the reaction proceeds during this period. Then, annealing may be performed on an as needed basis.

The description of the organic material in the first embodiment may be applied to the physical properties of the first and second organic materials.

The first and second organic materials may include at least one selected from the group consisting of the following (v) to (vi). The organic material for use may include one compound or two or more compounds in combination.

(v) a combination of a hydrolyzable hydrosilane or a substituted or unsubstituted hydrocarbon compound having a hydrolyzable silyl group at one terminal part and a hydrosilyl group at the other terminal part, and a substituted or unsubstituted hydrocarbon compound having a hydrolyzable silyl group at one terminal part and an alkenyl group at the other terminal part; and

(vi) a substituted or unsubstituted hydrocarbon compound having a hydrolyzable silyl group at one terminal part and an alkyl group at the other terminal part.

Specific description is as follows.

· Example of using organic material (v)

In the example, differences from the first example using the organic material (iii) described above will be mainly explained, and unless otherwise specified, the explanations described in the first example may be applied.

As the organic material, the first organic material and the second organic material are used in combination.

The first organic material can be a hydrolyzable hydrosilane or a substituted or unsubstituted hydrocarbon compound having a hydrolyzable silyl group at one terminal part and a hydrosilyl group at the other terminal part, and may be optionally a mixture thereof. The hydrolyzable hydrosilane may be one having H and one or more hydrolyzable groups on one Si. A substituted or unsubstituted hydrocarbon compound having a hydrolyzable silyl group at one terminal part and a hydrosilyl group at the other terminal part may have two or more terminal parts, and may have a hydrolyzable silyl group at any one or more terminal parts and a hydrosilyl group at any one or more terminal parts. A substituted or unsubstituted hydrocarbon compound having a hydrolyzable silyl group at one terminal part and a hydrosilyl group at the other terminal part may be the same as the substituted or unsubstituted hydrocarbon compound having hydrolyzable silyl groups at two terminal parts described in detail in the (iii), except for having a hydrosilyl group at the other terminal part.

The second organic material is a substituted or unsubstituted hydrocarbon compound having a hydrolyzable silyl group at one terminal part and an alkenyl group at the other terminal part. The compounds may have two or more terminal parts, and may have a hydrolyzable silyl group at any one or more terminal parts, and an alkenyl group at any one or more terminal parts. The substituted or unsubstituted hydrocarbon compound having a hydrolyzable silyl group at one terminal part and an alkenyl group at the other terminal part may be the same as the substituted or unsubstituted hydrocarbon compound having a hydrolyzable silyl group at two terminal parts described in detail in the (iii), except for having an alkenyl group at the other terminal part.

First, the first organic material is supplied to the bonding part 13. The hydrolyzable silyl group of the organic material react with the silanol groups of the first bonding part 13 (for example, in the case where the hydrolyzable group is an alkoxy group, a siloxane bonding is formed by dealcoholization).

Further, The second organic material is supplied to the second bonding part 23, so that the hydrolyzable silyl groups of the second organic material react with the silanol groups of the second bonding part 23 (for example, in the case where the hydrolyzable group is an alkoxy group, formation of siloxane bonds due to dealcoholization).

The first bonding part 13 and the second bonding part 23 are then disposed facing each other with an intermediate derived from the first organic material and an intermediate derived from the second organic material being located therebetween to cause a reaction of the intermediates (hydrosilylation). Thereby, the reaction product derived from the first organic material and the second organic material chemically bond to the Si atoms of the first bonding part 13 and the Si atoms of the second bonding part 23, so that the first bonding part 13 and the second bonding part 23 are bonded with the reaction product derived from the first organic material and the second organic material. Although an alcohol is produced as a by-product in such a reaction, the number of carbon atoms thereof can be small as described above, so that the by-product can be effectively removed before disposing the first bonding part 13 and the second bonding part 23 facing each other. Therefore, the formation of voids derived from by-products can be reduced.

For example, as the first organic material, $R^k{}_3Si\text{-}(CH_2)_{n37}\text{-}CH=CH_2$ may be used, and as the second organic material, $SiHR^k{}_3$ may be used. $R^k$ each independently mean a group to be subjected to hydrolysis reaction, which is specifically equivalent to the above. Incidentally, n37 is an integer of 0 to 18, for example, 0.

Specifically, in the case of using vinyltrimethoxysilane as the first organic material and using trimethoxy hydrosilane as the second organic material, the reaction is shown in the following.

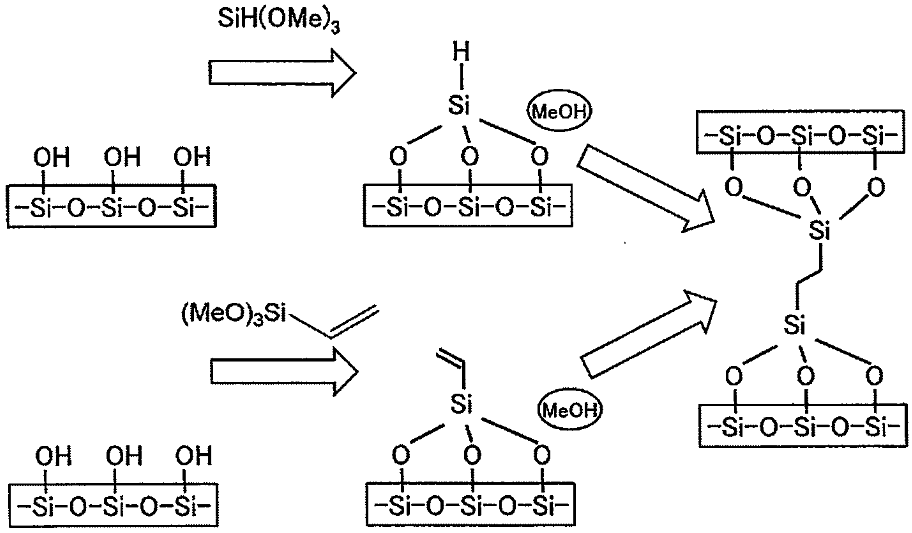


· Example of using organic material (vi)

In this example, the following description focuses on the different points from the first example in which the organic material (iii) is used, and unless otherwise specified, the same description as in the first example may apply below.

As the first and second organic materials, a substituted or unsubstituted hydrocarbon compound having a hydrolyzable silyl group at one terminal part and an alkyl group at the other terminal part, respectively, is used. The compound may have two or more terminal parts, and may have a hydrolyzable silyl group at any one or more terminal parts and an alkyl group at any one or more terminal parts. A substituted or unsubstituted hydrocarbon compound having a hydrolyzable silyl group at one terminal part and an alkyl group at the other terminal part may be the same as the substituted or unsubstituted hydrocarbon compound having hydrolyzable silyl groups at two terminal parts described in detail in the (iii), except for having an alkyl group at the other terminal part. The second organic material may have the same structure as that of the first organic material, or may have a different structure.

The first organic material is supplied to the first bonding part 13 so that the hydrolyzable silyl group of the first organic material reacts with the silanol groups of the first bonding part 13 (for example, in the case where the hydrolyzable group is an alkoxy group, a siloxane bonding is formed by dealcoholization). Further, the second organic material is supplied to the second bonding part 23 so that the hydrolyzable silyl group of the second organic material reacts with the silanol group of the second bonding part 23 (for example, in the case where the hydrolyzable group is an alkoxy group, a siloxane bonding is formed by dealcoholization). The first bonding part 13 and the second bonding part 23 are then disposed facing each other, with an intermediate derived from the organic material being located therebetween to cause a reaction between the intermediates (radical reaction). The reaction between the intermediates (radical reaction) may be performed by UV irradiation, ion beams, weak plasma, or the like. Thereby, the reaction product derived from the first and second organic materials chemically bonds to the Si atoms of the first bonding part 13 and the Si atoms of the second bonding part 23, so that the first bonding part 13 and the second bonding part 23 are bonded with a reaction product derived from the first and second organic materials. Although an alcohol is produced as a by-product in such a reaction, the number of carbon atoms thereof can be small as described above. As a result, the by-product can be effectively removed before disposing the first bonding part 13 and the second bonding part 23 facing each other, so that the formation of voids derived from by-products can be reduced.

For example, as the first organic material and the second organic material, $R^k{}_3Si(CH_2)_{n38}H$ may be used. $R^k$ each independently mean a group that may be subjected to a hydrolysis reaction, and specifically is the same as the above. Incidentally, n38 is an integer of 2 to 18, and, for example, 0.

Specifically, in the case of using ethyltrimethoxysilane as the first and second organic materials, the reaction is shown in the following.

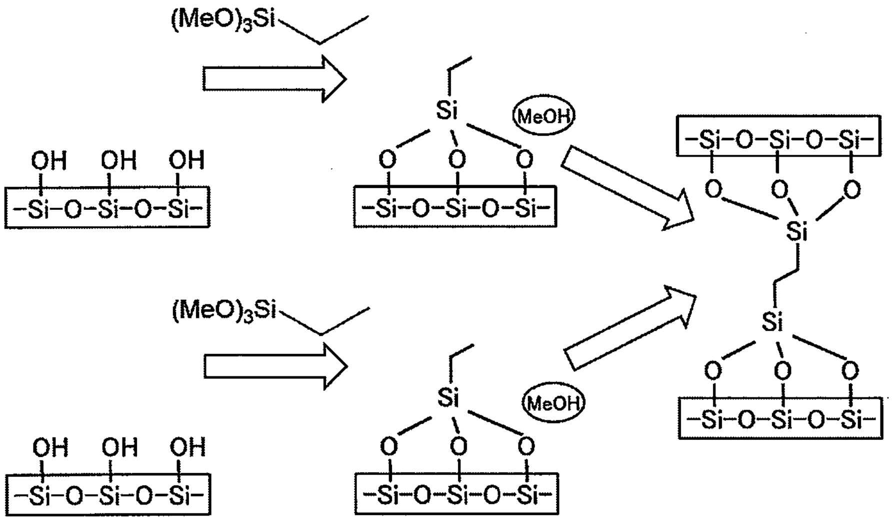

By the production method, the layered product 40A having the first silicon substrate 10, the second silicon substrate 20 and the adhesive layer 30A between the first silicon substrate 10 and the second silicon substrate 20 is formed, and the adhesive layer 30A has a first adhesive part 31A and a second adhesive part 32A.

The first and second organic materials may be obtained by filtering. The amounts of particles before filtering of the first and second organic materials and after filtering of the first and second organic materials are as defined in the first embodiment, respectively.

(First and second inorganic materials)

As the first and second inorganic materials, the inorganic materials in the first embodiment may be used.

The first and second inorganic materials may be obtained by filtering. The first and second inorganic materials before filtering and the first and second inorganic materials after filtering have similar particle amounts as in the inorganic materials in the first embodiment, respectively.

By the production method described above, a layered product 40 having a first silicon substrate 10, a second silicon substrate 20, and an adhesive layer 30A between the first silicon substrate 10 and the second silicon substrate 20 is formed. In other words, the method for producing a layered product 40A in the second embodiment includes:

(a) providing a first silicon substrate 10 having a first bonding part 13 and a second silicon substrate 20 having a second bonding part 23, with the first bonding part 13 and the second bonding part 23 containing silicon oxide, and
(b) by using first and second organic materials reactable with a hydrosilyl group and/or a silanol group, disposing an adhesive layer 30A that bonds the first bonding part 13 and the second bonding part 23 with first and second organic materials or a reaction product derived from the first and second organic materials, or by using first and second inorganic materials reactable with silicon oxide, disposing an adhesive layer 30A that bonds the first bonding part 13 and the second bonding part 23 with the first and second inorganic materials and/or the first and second organic materials;

wherein, the adhesive layer 30A includes a first adhesive part 31A disposed on the first bonding part 13 and a second adhesive part 32A disposed on the second bonding part 23; and
the number of clusters of particles contained in the surface of the first adhesive part 31A on the opposite side of the first bonding part 13 is 5 pieces/$cm^2$ or less. The numbers of particles and clusters are as defined in the first embodiment. In the present specification, "first and second organic materials and/or a reaction product derived from the first and second organic materials" may be described as "a reaction product derived from the first and second organic materials" in some cases.

Further, a layered product 40A includes:

a first silicon substrate 10 having a first bonding part 13 on at least a part of the surface;
a second silicon substrate 20 having a second bonding part 23 on at least a part of the surface located on the side of the bonding part 13; and
an adhesive layer 30A that is located between the first bonding part 13 and the second bonding part 23 and that bonds

the first bonding part 13 of the first silicon substrate 10 and the second bonding part 23,
wherein the adhesive layer 30A has a reaction product between a first adhesive part 31A located on the first bonding part 13 and a second adhesive part 32A located on the second bonding part 23, or a bonded material between a first adhesive part 31A located on the first bonding part 13 and a second adhesive part 32A located on the second bonding part 23,
the layered product has electric conductivity between the first silicon substrate 10 and the second silicon substrate 20.

(Modified example)

Figure 3 is a schematic cross-sectional diagram showing a part of a layered product 40B in a modified example. In the modified example in contrast to the second embodiment, a first adhesive part 31B is present on the first bonding part 13, a second adhesive part 32B is present on the second bonding part 23, and a third adhesive part 33B is present between the first adhesive part 31B and the second adhesive part 32B, respectively, so that the first adhesive part 31B and the third adhesive part 33B are bonded and the second adhesive part 32B and the third adhesive part 33B are bonded. In other words, the adhesive layer 30B includes three layers: the first adhesive part 31B, the third adhesive part 33B, and the second adhesive part 32B. The different structure is described as follows. Other structure is the same as in the first embodiment, so that the description is omitted. In the present embodiment, "first adhesive part" described in claims corresponds to the first adhesive part 31B and the third adhesive part 33B, and "second adhesive part" corresponds to the second adhesive part 32B, respectively.

(Adhesive layer 30B)

The adhesive layer 30B has a first adhesive part 31B, a third adhesive part 33B and a second adhesive part 32B in this order. The first adhesive part 31B is disposed on the first silicon substrate 10, the second adhesive part 32B is disposed on the second silicon substrate 20, and the third adhesive part 33 is reactable with the first adhesive part 31B at one terminal part, and reactable with the second adhesive part 32B at the other terminal part. In other words, the third adhesive part 33 is reactable as connection part that connects the first adhesive part 31B to the second adhesive part 32B. The reaction is performed under heated and/or increased or decreased pressure on an as needed basis. The conditions for heating and increasing or decreasing pressure are the same as in the first embodiment.
The thickness of the adhesive layer 30B may be extremely thin. The thickness of the adhesive layer 30B may be, for example, 10 nm or less, and 8 nm or less, in particular, and the lower limit may be, for example, 1 nm or more, though not limited thereto.
The first adhesive part 31B may be obtained by coating the first organic material reactable with the first bonding part 13 on the first bonding part 13, and then drying the resultant. The drying may be performed in the same manner as in the first embodiment.
The second adhesive part 32B may be obtained by coating the second organic material reactable with the second bonding part 23 on the second bonding part 23, and then drying the resultant. The drying may be performed in the same manner as in the first embodiment.
Regarding a third adhesive part 33B, by coating a third organic material reactable with the first organic material and the second organic material, and then drying the resultant on an as needed basis, the third organic material and/or a reaction product derived from the third organic material can be formed. The drying may be performed in the same manner as in the first embodiment. Incidentally, "third organic material and/or a reaction product derived from the third organic material" may be referred to as "reaction product derived from the third organic material".
In another aspect, the first adhesive part 31B may be obtained by supplying a first inorganic material bondable to the first bonding part 13 on the first bonding part 13, and then drying the material on an as needed basis. The drying may be performed in the same manner as in the first embodiment.
The second adhesive part 32B may be obtained by supplying a second inorganic material bondable to the second bonding part 23 on the second bonding part 23, and then drying the material on an as needed basis. The drying may be performed in the same manner as in the first embodiment.
The third adhesive part 33B is formed by coating a third inorganic material bondable to the first organic material and the second organic material, and then drying the resultant on an as needed basis. The drying may be performed in the same manner as in the first embodiment.
The first adhesive part 31B, the second adhesive part 32B, and the third adhesive part 33B described for convenience may have no boundary surface. In the case where a boundary surface is formed, the boundary surface may not be a uniform surface, or may be uneven. Alternatively, the organic material and the inorganic material may be appropriately combined for use.
The number of clusters of particles contained in the surface of the first adhesive part 31B on the opposite side of the first bonding part 13 is 5 pieces/$cm^2$ or less. The numbers of particles and clusters are as defined in the first

embodiment, respectively.

Preferably, the number of clusters of particles contained in the surface of the second adhesive part 32B on the opposite side of the second bonding part 23 is 5 pieces/$cm^2$ or less. The lower limit of the number of clusters is, for example, 0 piece/$cm^2$ or more, though not limited thereto.

Preferably, the number of clusters of particles contained in the surface of the third adhesive part 33B on the opposite side of the first adhesive part 31B is 5 pieces/$cm^2$ or less. The lower limit of the number of clusters is, for example, 0 piece/$cm^2$ or more, though not limited thereto.

(First to third organic materials)

The first organic material has a functional group reactable with the first bonding part 13 at one terminal part, and a functional group reactable with the third organic material at the other terminal part. The second organic material has a functional group reactable with the second bonding part 23 at one terminal part, and a functional group reactable with the third organic material at the other terminal part. The third organic material has a functional group reactable with the first organic material at one terminal part, and a functional group reactable with the second organic material at the other terminal part. Thereby, the first silicon substrate 10 is bonded to the second silicon substrate 20. Incidentally, only a part of these functional groups may cause a reaction. Although the case where one organic material has two functional groups is described above, the organic material may have three or more functional groups.

The first to third organic materials each may be used as a composition. The composition has the same structure as in the first embodiment.

The specific aspects of the methods for supplying and bonding the first to third organic materials (or a composition containing the first to third organic materials) may be appropriately selected depending on the organic material for use. Schematically, after supplying the first to third organic materials, in a state with the organic materials lying between the first silicon substrate 10 and the second silicon substrate 20, the first silicon substrate 10 and the second silicon substrate 20 are maintained under specified reaction conditions (at specified temperature, in particular), such that the reaction proceeds.

More specifically, for example, the first organic material (which may be a composition) is applied (for example, by coating, spraying, printing, etc.) to the surface of the first silicon substrate 10 on the side having the first bonding part 13. In the same way, the second organic material (which may be a composition) is applied to the second bonding part 23 of the second silicon substrate. Then, washing and/or drying may be performed on an as needed basis. In the washing and drying, the same described above may be applied. In the case of using an organic material containing fluorine, pre-washing with use of a fluorine-based solvent may be performed.

Then, the third organic material (which may be a composition) is applied (for example, by coating, spraying, printing, etc.) on the region derived from the first organic material. Then, washing and/or drying may be performed on an as needed basis. In the washing and drying, the same described above may be applied. In the case of using an organic material containing fluorine, pre-washing with use of a fluorine-based solvent may be performed.

Further after that, a region derived from the second organic material is disposed on the region derived from the third organic material. Specifically, the first silicon substrate 10 and the second silicon substrate 20 are aligned such that the first bonding part 13 are faced to the second bonding part 23. Thereby, the first silicon substrate 10 comes into close contact with the second silicon substrate 20 with the first to third organic materials lying between the first bonding part 13 and the second bonding part 23. The first silicon substrate 10 and the second silicon substrate 20 that are in close contact are maintained under specified conditions (at specified temperature, in particular) such that the reaction proceeds during this period. Then, annealing may be performed on an as needed basis.

The physical properties and the constituent materials of the first to third organic materials are the same as those of the first organic material in the first embodiment.

Each of the organic materials is shown as follows. The following description focuses on the different points from the first example in which the organic material (iii) is used, and unless otherwise specified, the same description as in the first example may apply below.

As the organic materials, the following materials may be used.

(vii) a substituted or unsubstituted hydrocarbon compound having a hydrolyzable silyl group at one terminal part and a reactive functional group at the other terminal part

Illustrative aspects are described in detail as follows.

·Example using organic material (vii)

In this example, the following description focuses on the different points from the first example with use of the organic material (iii), and unless otherwise specified, the same description as in the first example is applicable.

As the first and second organic materials, a substituted or unsubstituted hydrocarbon compound having a

hydrolyzable silyl group at one terminal part and a reactive functional group at the other terminal part is used. The compound may have two or more terminal parts, and may have a hydrolyzable silyl group at any one or more terminal parts and a reactive functional group at any one or more terminal parts. The first and second organic materials may be the same as the substituted or unsubstituted hydrocarbon compound having a hydrolyzable silyl group at two terminal parts described in detail in the (iii), except for having a reactive functional group at the other terminal part. Incidentally, except for the terminal part, the first organic material and the second organic material may have the same structure or may have a different structure.

The reactive functional group may be typically at least one selected from the group consisting of an isocyanate group, an amino group, a hydroxyl group, a thiol group (also referred to as sulfanyl group), etc., though not limited thereto.

In the present embodiment, a third organic material is further used. The third organic material has two groups bondable to a reactive functional group of the first and second organic materials. The third organic material may have two or more bindable groups, and more specifically may have the bindable groups at any two or more terminal parts. The number of carbons of the portion of the third organic material except for the bindable group is not limited, and may be, for example, 1 or more and 20 or less, particularly 5 or less. The portion except for the bindable group may be in a linear, branched or cyclic form. Typically, the third organic material may be a linear organic compound having a bindable group at both terminal parts, though not limited thereto.

The bindable group is selected depending on the reactive functional group. Examples of the combination of the reactive functional group and the group bindable thereto are shown in the following, though not limited thereto. One or more reactive functional groups may be used, and one or more bindable groups may be used as long as they can be bindable to the reactive functional groups.

[Table 1]

| Reactive functional group in organic material | Bondable group in organic bonding agent |
|---|---|
| Isocyanate group | Amino group, Hydroxyl group, Thiol group |
| Amino group | Isocyanate group |
| Hydroxyl group | Isocyanate group |
| Thiol group | Isocyanate group |

The reactive functional group and the bondable group may be one that is reactive or substantially nonreactive with a hydrosilyl group and/or a silanol group. In the case where all of the reactive functional groups and the bondable groups are the ones reactive with a hydrosilyl group and/or a silanol group, it is possible to consider use of two types of organic materials (iii), which is not taken into consideration in the case of using the organic material (vii).

For example, in the case of using $R^k{}_3Si-(CH_2)_{n31}-NCO$ as the first organic material and the second organic material, for example, at least one of $H_2N-(CH_2)_{n32}-NH_2$, $HS-(CH_2)_{n32}-SH$, and $HO-(CH_2)_{n32}-OH$, may be used as the third organic material. In the case of using $R^k{}_3Si-(CH_2)_{n33}-NH_2$ as the first organic material and the second organic material, $OCN-(CH_2)_{n34}-NCO$ may be used as the third organic material. Incidentally, n31 is an integer of 1 to 18, and, for example, 1. Further, n32 are an integer of 1 to 18, and, for example, 2. Further, n33 is an integer of 1 to 18, and, for example, 1. Further, n34 is an integer of 1 to 18, and, for example, 2.

$R^k$ means a group that is subject to a hydrolysis reaction, preferably each independently are $-OR^j$, $-OCOR^j$, $-O-N=CR^j{}_2$, $-NR^j{}_2$, $-NHR^j$ or a halogen. $R^j$ is a substituted or unsubstituted $C_{1-4}$ alkyl group, preferably an unsubstituted $C_{1-4}$ alkyl group. The $C_{1-4}$ alkyl group is preferably an ethyl group or a methyl group, more preferably a methyl group.

Specifically, in the case of using isocyanate methyl trimethoxysilane as the first organic material and the second organic material, and ethylene diamine(1,2-diaminoethane) as the third organic material, the reaction is described as follows. In the following schematic diagram, the upper row shows the bonding part of one substrate only for convenience. The first method corresponds to the scheme indicated by the arrow pointing from the left side of the upper row to the lower row. The second method corresponds to the scheme indicated by the arrow pointing from the left side of the upper row to the center of the upper row and the arrow pointing from the center of the upper row to the lower row. The third method corresponds to the scheme indicated by the arrow pointing from the left side of the upper row to the center of the upper row, the arrow pointing from the center of the upper row to the right side of the upper row, and the arrow pointing from the right side of the upper row to the lower row (the same shall apply hereinafter).

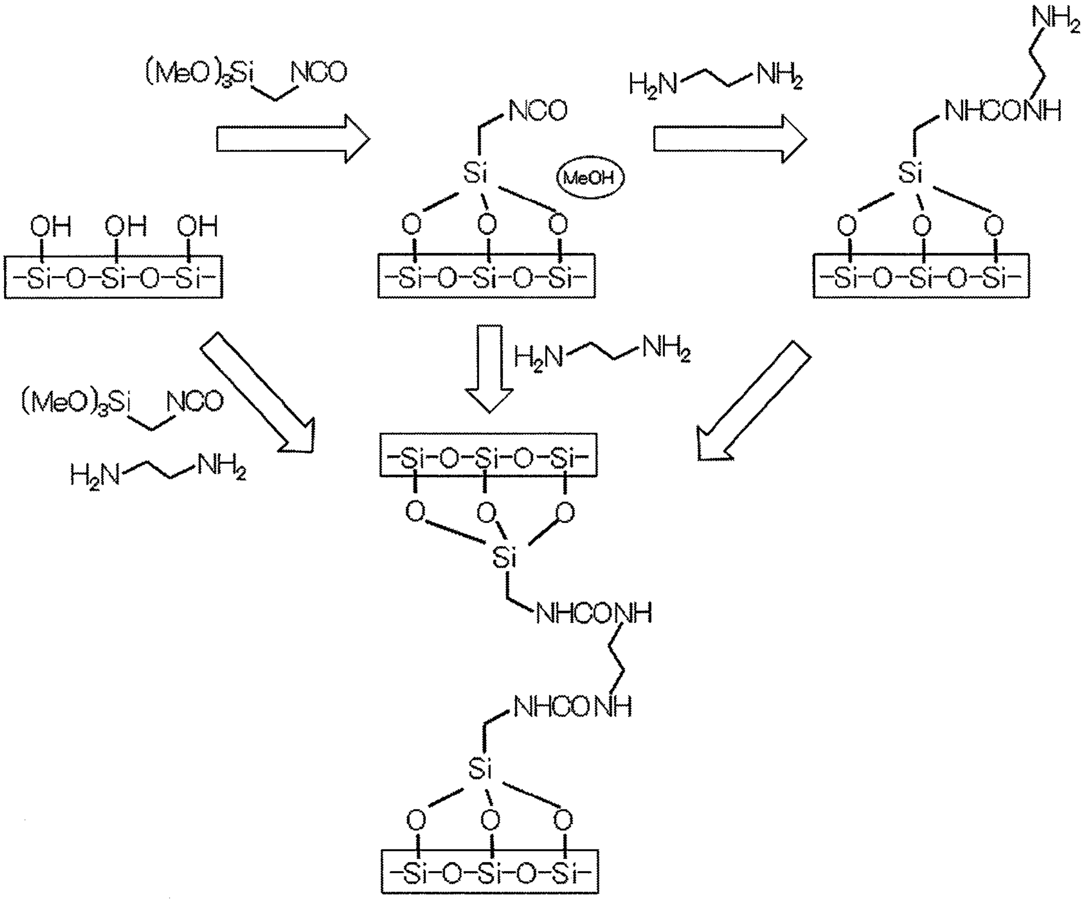

Specifically, a reaction with use of isocyanatomethyl trimethoxysilane as the first and second organic materials and 1,2-ethane dithiol as the third organic material is shown in the following.

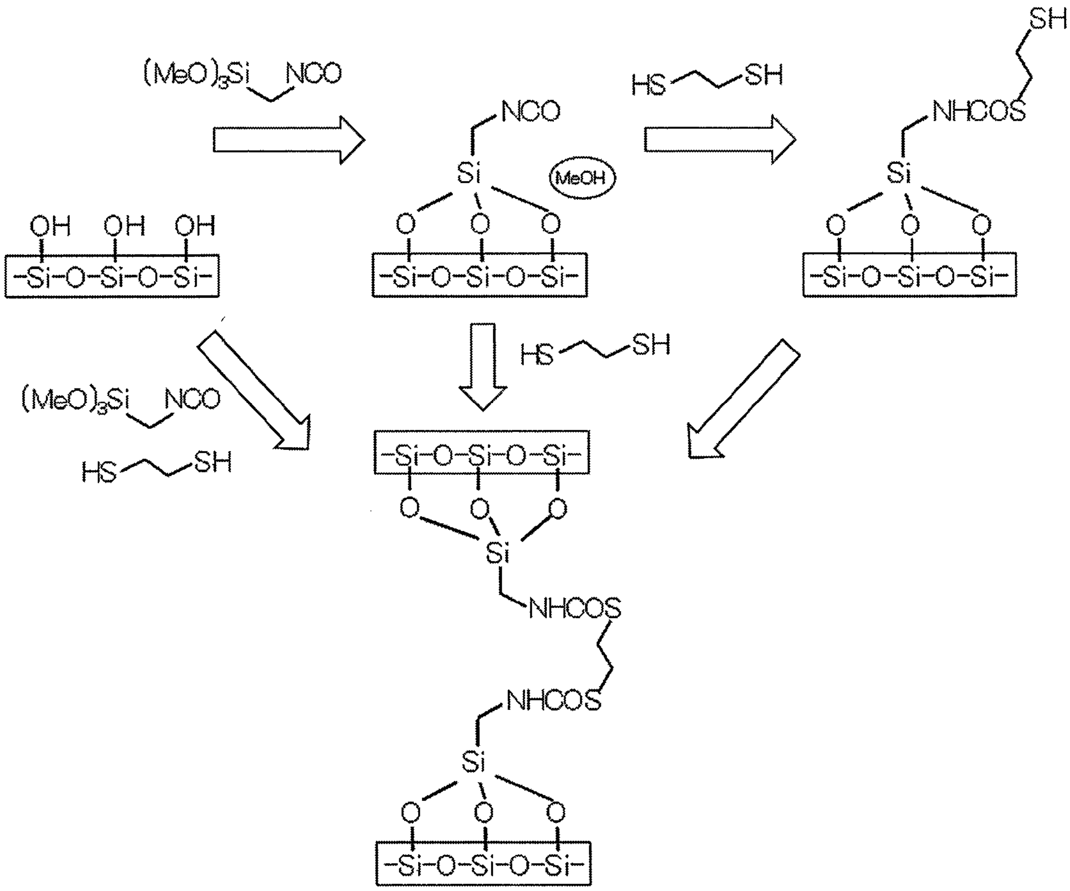

Specifically, in the case of using isocyanate methyl trimethoxysilane as the first organic material and the second organic material, and ethylene glycol (1,2-ethane diol) as the third organic material, the reaction is described as follows.

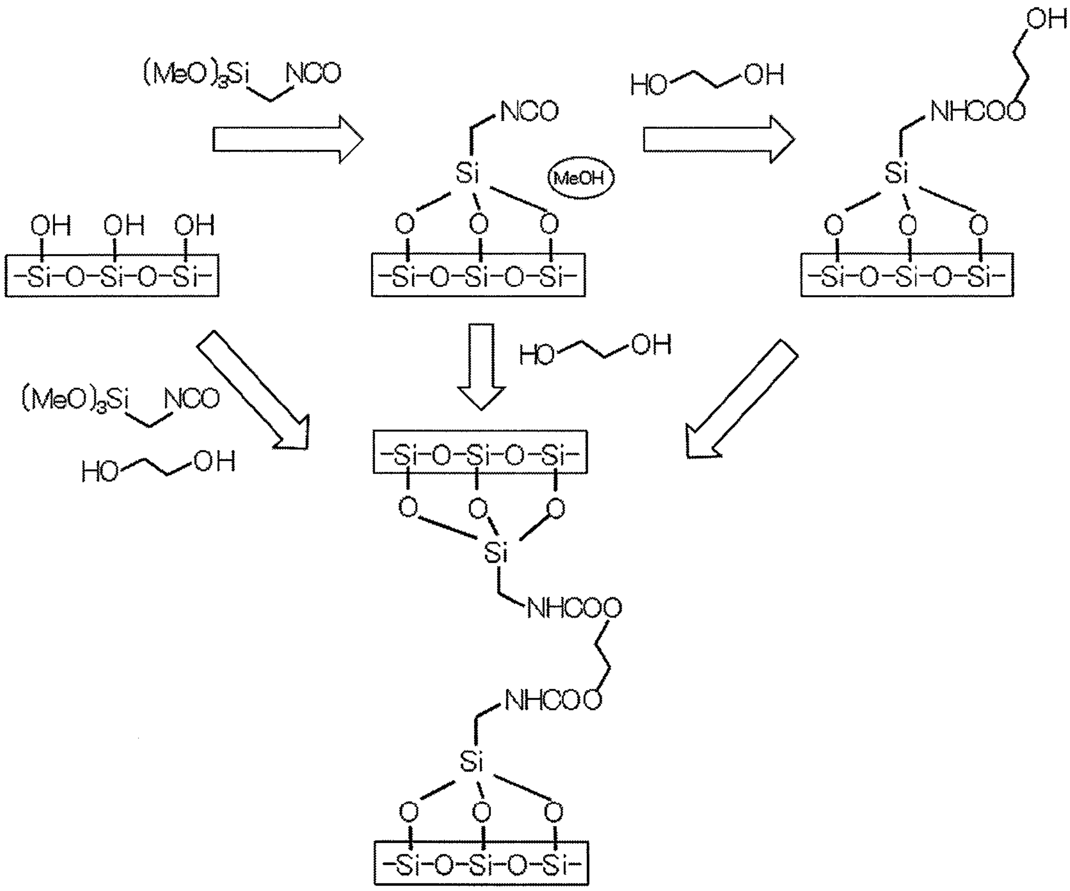

Specifically, in the case of using aminomethyl trimethoxysilane as the first and second organic materials, and ethylene diisocyanate(1,2-ethane diisocyanate) as the third organic material, the reaction is described as follows.

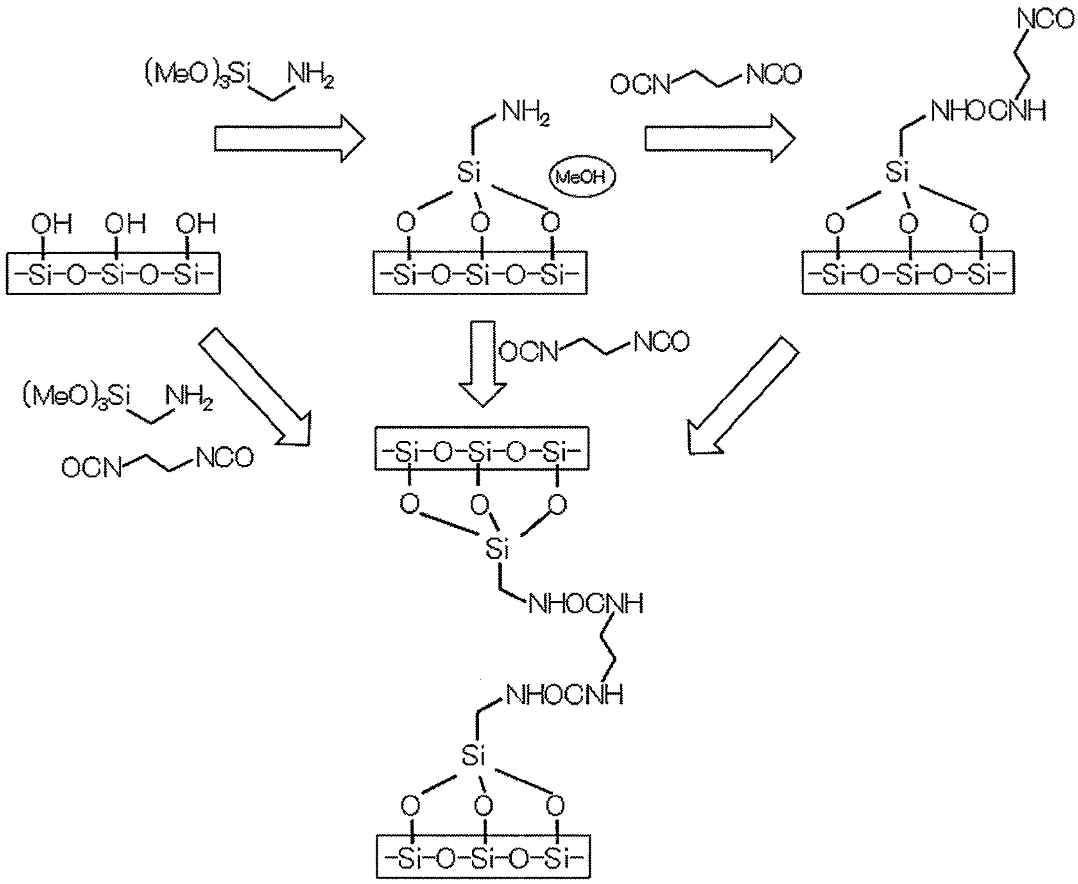

Any appropriate scheme may be applied to the method for bonding the first bonding part 13 and the second bonding part 23 with use of the first to third organic materials B. Three methods are shown in the following, though not limited thereto.

(First method)

In the first method, the first and second organic materials and the third organic material are mixed (for example, immediately before use), and the resulting mixture is supplied between the first bonding part 13 and the second bonding part 23, so that the hydrolyzable silyl groups of the first and second organic materials react with the silanol groups of the first bonding part 13 and the second bonding part 23 (for example, in the case where the hydrolyzable group is an alkoxy group, formation of siloxane bond due to dealcoholization). Thereby, the first organic material chemically bonds to the Si atoms of the first bonding part 13 and the second organic material chemically bonds to the Si atoms of the second bonding part 23.

Also, the reactive functional groups of the first and second organic materials and the bondable groups of the third organic material are bonded through a reaction. Thereby, the first organic material chemically bonded to the Si atoms of the first bonding part 13 and the second organic material chemically bonded to the Si atoms of the second bonding part 23 are bonded through the third organic material.

The reaction between the hydrolyzable silyl groups of the first organic material and the hydrolyzable silyl groups of the first bonding part 13 and the first organic material and the silanol groups of the second bonding part 23, and the reaction between the reactive functional groups of the first and second organic materials and the bondable groups of the third organic material may occur at any timing, and for example, any of the reactions may proceed in advance, or the reactions may proceed at the same time. As a result, the first bonding part 13 and the second bonding part 23 are bonded by the reaction product derived from the first to third organic materials. Although, for example, an alcohol is produced as a by-product, the number of carbon atoms thereof can be small as described above, so that the by-product can be effectively removed to the outside through a gap of the reaction products between the first bonding part 13 and the second bonding part 23. Accordingly, the formation of voids derived from by-products can be suppressed.

(Second method)

In a second method, a first organic material is supplied to the first bonding part 13 so that the hydrolyzable silyl

groups of the first organic material 5 react with the silanol groups of the first bonding part 13 (for example, in the case where the hydrolyzable group is an alkoxy group, a siloxane bonding is formed by dealcoholization), and a second organic material is supplied to the second bonding part 23 so that the hydrolyzable silyl group of the second organic material reacts with the silanol group of the second bonding part 23 (for example, in the case where the hydrolyzable group is an alkoxy group, a siloxane bonding is formed by dealcoholization). (The first organic material to be supplied to the first bonding part 13 and the second organic material to be supplied to the second bonding part 23 may be the same or different.) Thereby, the first organic material chemically bonds to the Si atoms of the first bonding part 13 and the second organic material chemically bonds to the Si atoms of the second bonding part 23, respectively.

The first bonding part 13 and the second bonding part 23 are then disposed facing each other, with an intermediate derived from the first and second organic materials lying therebetween together with the third organic material, so as to bond the reactive functional groups of the first and second organic materials to the bondable group of the third organic material through a reaction. Thereby, the first organic material chemically bonded to the Si atoms of the first bonding part 13 and the second organic material chemically bonded to the Si atoms of the second bonding part 23 are bonded through the third organic material.

As a result, the first bonding part 13 and the second bonding part 23 are bonded by the reaction product derived from the first to third organic materials. Although, for example, an alcohol is produced as a by-product, the number of carbon atoms thereof can be small as described above, so that the by-product can be effectively removed before disposing the first bonding part 13 and the second bonding part 23 facing each other. Accordingly, the formation of voids derived from by-products can be suppressed.

(Third method)

In a third method, a first organic material is supplied to the first bonding part 13 so that the hydrolyzable silyl group of the first organic material reacts with the silanol group of the first bonding part 13 (for example, in the case where the hydrolyzable group is an alkoxy group, a siloxane bonding is formed by dealcoholization), and the second organic material is supplied to the second bonding part 23 so that the hydrolyzable silyl group of the second organic material reacts with the silanol group of the second bonding part 23 (for example, in the case where the hydrolyzable group is an alkoxy group, a siloxane bonding is formed by dealcoholization). (The first organic material to be supplied to the first bonding part 13 and the second organic material to be supplied to the second bonding part 23 may be the same or different.) Thereby, the first organic material chemically bonds to the Si atoms of the first bonding part 13 (intermediate X1), and the second organic material chemically bonds to the Si atoms of the second bonding part 23 (intermediate X2). Then, the intermediate X1 is conveniently selected as one of the intermediates X1 and X2, and a third organic material is supplied to the first bonding part 13, so that the reactive functional group of the first organic material is bonded to the bondable group of the third organic material through a reaction (intermediate Y).

Then the intermediate Y thus obtained and the intermediate X2 obtained in the above are disposed facing each other, such that, between them, the intermediate Y derived from the third organic material is disposed on the side of the first bonding part 13, and the intermediate X2 derived from the second organic material is disposed on the side of the second bonding part 23. The reactive functional group of the intermediate X2 (the second organic material) and the bondable group of the intermediate Y (the first organic material + the third organic material) are bonded through a reaction. Thereby, the first organic material chemically bonded to the Si atoms of the first bonding part 13 and the second organic material chemically bonded to the Si atoms of the second bonding part 23 are bonded through the third organic material.

As a result, the first bonding part 13 and the second bonding part 23 are bonded by the reaction product derived from the first to third organic materials. Although, for example, an alcohol is produced as a by-product, the number of carbon atoms thereof can be small as described above, so that the by-product can be effectively removed before disposing the first bonding part 13 and the second bonding part 23 facing each other. Accordingly, the formation of voids derived from by-products can be suppressed. Further, in this method, the unreacted organic binding agent that may remain on the second bonding part can be effectively removed before disposing the first bonding part 13 and the second bonding part 23 facing each other. Accordingly, in a layered product to be finally obtained, the unnecessary substances (not contributing to bonding) remaining between the first bonding part 13 and the second bonding part 23 can be reduced.

The embodiment of the present disclosure has been described above, though the present disclosure is not limited to the embodiment and various modifications may be made.

Example

The present disclosure is more specifically described with reference to the following examples, though not limited thereto.

(Example 1)

First, propyleneglycol monomethyl ether acetate as washing solvent and 30 wt% 1,6-bis(trimethoxysilyl) hexane/propyleneglycol monomethyl ether acetate solution each was filtered to remove particles.

A 4-inch silicon wafer having a thermally oxidized film was set on a plasma device and subjected to plasma application at 250 W for 3 minutes. The wafer was set on a spin coater, and 30 wt% 1,6-bis(trimethoxysilyl)hexane/propylene glycol monomethyl ether acetate solution was dropped thereto. After standing still for 5 minutes, spin-coating at 2,000 rpm was performed for 30 seconds. Further, propyleneglycol monomethyl ether acetate as washing solvent was dropped on the wafer to be spin-dried at 2,000 rpm for 30 seconds. The wafer was treated on a hot plate at 100°C for 5 minutes, and then loaded on a jig for attaching by hand. Another silicon wafer after being subjected to the similar plasma application at 250 W for 3 minutes was stacked thereon to be bonded. Then, a 2-kg weight was placed on the wafers, which were heated in an oven at 200°C for 30 minutes.

{Conditions for plasma application}

The plasma application was performed by using the following apparatus.

· Apparatus: Aqua Plasma (registered trademark) cleaner AQ-500 manufactured by SUMCO Corporation.
· Plasma for application: $H_2O$
· Application time: 3 minutes
· Application temperature: normal temperature

{Filtering}

· Effective diameter of filter: 50 nm

{Measurement of bonding strength}

The bonding strength γ was measured by a blade test, in which a razor blade was inserted between wafers to observe the peeling distance with an infrared microscope. The bonding strength γ is represented by the following formula.

$$\gamma=(3Ed^3y^2)/(32L^4)$$

wherein, E is Young's modulus of wafer, Y is thickness of blade, d is thickness of wafer, and L is peeling distance.

{Amount of particles}

The amount of particles in the composition was measured by using a syringe sampling system SLS-1040 to determine the amount of particles having a size of 40 nm or more in the composition.

{Inspection of surface foreign matter}

In the inspection of the surface foreign matter, a 300 mm-silicon wafer having a naturally oxidized film was used. After performing the similar surface activation (plasm application) with a plasma apparatus (Aqua Plasma (registered trademark) cleaner AQ-2000 manufactured by SUMCO Corporation), 1,6-bis(trimethoxysilyl)hexane/propylene glycol monomethyl ether acetate solution in Example 1 was coated on a spin coater for 300 mm. From the center of the rotating wafer, 40 ml of propylene glycol monomethyl ether acetate was discharged, so that a washed wafer was obtained.

The number of clusters of particles of wafer was measured using a surface foreign matter inspecting device. The wafer is a 300-mm wafer having an area of 706.8 $cm^2$.

(Example 2)

The same procedure was done as in Example 1, except that bis[3-(trimethoxysilyl)propyl]amine was used as the first organic material instead of 1,6-bis(trimethoxysilyl)hexane in Example 1.

(Example 3)

The same procedure was done as in Example 1, except that hexamethylene diisocyanate was used as the first

organic material instead of 1,6-bis(trimethoxysilyl)hexane in Example 1.

The same procedure was done as in Example 3, except that filtering was not performed.

In Table 2, the amount of particles in the washing solvent and the effective diameter of the filter used for removing the particles are shown. In Table 3, the effective diameter of the filter and the amount of particles in the composition containing the first organic solvent are shown. In Table 4, the bonding temperature, the number of clusters and the bonding strength of the adhesive layer are shown.

[Table 2]

| | | Effective diameter of filter (nm) | Amount of particle | |
|---|---|---|---|---|
| | | | Before removal by filtering (pieces/mL) | After removal by filtering (pieces/mL) |
| Washing solution | Propylene glycol monomethyl ether acetate | 50 | 11085 | 322 |

[Table 3]

| | Effective diameter of filter (nm) | Amount of particle | |
|---|---|---|---|
| | | Before removal by filtering (pieces/mL) | After removal by filtering (pieces/mL) |
| Example 1 | 50 | >25000 | 391 |
| Example 2 | 50 | >25000 | 459 |
| Example 3 | 50 | >25000 | 2251 |
| Comparative Example 1 | - | >25000 | - |

[Table 4]

| | Bonding temperature (°C) | Number of clusters of surface particles | | Bonding strength ($J/m^2$) |
|---|---|---|---|---|
| | | (pieces/wafer) | (pieces/$cm^2$) | |
| Example 1 | 200 | 767 | 1.09 | 1.21 |
| Example 2 | 200 | 872 | 1.23 | 1.30 |
| Example 3 | 200 | 1839 | 2.60 | 1.14 |
| Comparative Example 1 | 200 | 41832 | 59.2 | 0.90 |

(Example 4)

First, as washing solvents, ethanol, propyleneglycol monomethyl ether acetate, 30 wt% 3-aminopropyl dimethoxy methyl silane/ethanol solution, and 30 wt% hexamethylene diisocyanate/propyleneglycol monomethyl ether acetate solution were filtered, respectively, to remove particles.

Two 4-inch silicon wafers having a thermally oxidized film were set on a plasma apparatus and subjected to plasma application at 250 W for 3 minutes. The wafers were set on a spin coater, and 30 wt% 3-aminopropyl dimethoxy methyl silane (first and second organic material)/ethanol solution was dropped thereto. After standing still for 5 minutes, spin-coating at 2,000 rpm was performed for 30 seconds. Further, propyleneglycol monomethyl ether acetate as washing solvent was dropped on the wafer to be spin-dried at 2,000 rpm for 30 seconds. The two wafers were treated on a hot plate at 100°C for 5 minutes, and one of them was further subjected to spin-coating of 30 wt% hexamethylene diisocyanate (third organic material)/propyleneglycol monomethyl ether acetate solution and spin-drying with propyleneglycol monomethyl ether acetate as washing solvent in the same manner, and then heat-treated at 100°C for 5 minutes. The two wafers were bonded with a jig for attaching by hand, such that the adhesive layer was disposed inside. Then, a 2-kg weight was placed on the wafers, which were heated at 200°C for 30 minutes.

(Example 5)

The same procedure was done as in Example 4, except that the concentrations of the first organic material and the second organic material were changed.

In Table 5, the amount of particles in the washing solvent and the effective diameter of the filter used for removing the particles are shown. In Table 6, the concentration of the organic material is shown. In Tables 7 to 9, the effective diameter of the filter, the amount of particles and the number of clusters are shown. In Table 10, the bonding temperature and the bonding strength are shown.

[Table 5]

| | | Effective diameter of filter (nm) | Amount of particle | |
|---|---|---|---|---|
| | | | Before removal by filtering (pieces/mL) | After removal by filtering (pieces/mL) |
| Washing solution | Ethanol | 50 | 13832 | 348 |
| | Propylene glycol monomethyl ether acetate | 50 | 11085 | 322 |

[Table 6]

| | First organic material: 3-aminopropyl dimethoxy methyl silane content (weight %) | Third organic material: hexamethylene diisocyanate content (weight %) | Second organic material: 3-aminopropyl dimethoxy methyl silane content (weight %) |
|---|---|---|---|
| Example 4 | 30 | 30 | 30 |
| Example 5 | 5 | 30 | 5 |

[Table 7]

| Example 4 | Effective diameter of filter (nm) | Amount of particle (in solution containing organic material) | | Number of clusters of surface particles | |
|---|---|---|---|---|---|
| | | Before removal by filtering (pieces/mL) | After removal by filtering (pieces/mL) | (pieces/wafer) | (pieces/$cm^2$) |
| First organic material | 50 | 8502 | 420 | 836 | 1.18 |
| Second organic material | 50 | >25000 | 2251 | 2631 | 3.72 |
| Third organic material | 50 | 8502 | 420 | 828 | 1.17 |

[Table 8]

| Example 5 | Amount of particle (in solution containing organic material) | | Number of clusters of surface particles | |
|---|---|---|---|---|
| | Before removal (pieces/mL) | After removal (pieces/mL) | (pieces/wafer) | (pieces/$cm^2$) |
| First organic material | 7138 | 385 | 740 | 1.05 |
| Second organic material | >25000 | 2251 | 2438 | 3.31 |
| Third organic material | 7138 | 385 | 782 | 1.11 |

[Table 9]

| | Bonding temperature (°C) | Bonding strength (J/$m^2$) |
|---|---|---|
| Example 4 | 200 | 1.4 |
| Example 5 | 200 | 1.3 |

(Example 6)

First, as washing solvents, propyleneglycol monomethyl ether acetate and 0.2 wt% bis[3-(trimethoxysilyl)propyl] amine/propylene glycol monomethyl ether acetate solution were filtered respectively to remove particles.

A 4-inch silicon wafer having a thermally oxidized film were set on a plasma apparatus and subjected to plasma application at 250 W for 3 minutes. The wafer was set on a spin coater, and 0.2 wt% bis[3-(trimethoxysilyl)propyl] amine/propyleneglycol monomethyl ether acetate solution was dropped thereto to perform spin-coating at 2,000 rpm for 30 seconds. After standing still for 5 minutes, propyleneglycol monomethyl ether acetate (water content: 5.5 wt%) as washing solvent was dropped on the wafer, and after standing still for 10 minutes, the wafer was spin-dried at 2,000 rpm for 30 seconds. The wafer was treated on a hot plate at 100°C for 5 minutes, and then loaded on a jig for attaching by hand. Another silicon wafer subjected to the same application using the plasma apparatus at 250 W for 3 minutes was stacked thereon to be bonded. Then, a 2-kg weight was placed on the wafers, which were heated in an oven at 200°C for 7 hours.

In Table 10, the amount of particles in the washing solvent and the effective diameter of the filter used for removal of the particles are shown. In Table 11, the bonding temperature and the number of clusters are shown.

[Table 10]

| | Effective diameter of filter (nm) | Number of particles | |
|---|---|---|---|
| | | Before removal by filtering (pieces/mL) | After removal by filtering (pieces/mL) |
| Example 6 | 50 | 15,500 | 210 |

[Table 11]

| | Bonding temperature (°C) | Number of clusters of surface particles | | Bonding strength ($J/m^2$) |
|---|---|---|---|---|
| | | (pieces/wafer) | (pieces/$cm^2$) | |
| Example 6 | 200 | 432 | 0.61 | 1.31 |

## Industrial Applicability

With use of the method for producing a layered product of the present disclosure, the bonding strength between a first silicon substrate and a second silicon substrate can be enhanced.

## Reference Signs List

10, 20: silicon substrate
11, 21: body part
13, 23: bonding part
30, 30A, 30B: adhesive layer
31, 31A, 32A, 31B, 32B, 33B: adhesive part
40, 40A, 40B: layered product

## Claims

**1.** A method for producing a layered product including two silicon substrates, comprising:

(a) providing a first silicon substrate having a first bonding part and a second silicon substrate having a second bonding part, wherein the first bonding part and the second bonding part each include silicon oxide;
(b) providing a first composition including at least one of an organic material reactable with a hydrosilyl group and/or a silanol group, and an inorganic material bondable to silicon oxide, and having an amount of particles of 3,000 pieces/mL or less; and
(c) with use of at least one of the organic material and the inorganic material, disposing an adhesive layer that bonds the first bonding part and the second bonding part with the organic material and/or a reaction product

derived from the organic material, or bonds the first bonding part and the second bonding part with the inorganic material and/or a reaction product derived from the inorganic material,

wherein the adhesive layer includes a first adhesive part disposed on the first bonding part, and
the number of clusters of the particles included in the surface of the first adhesive part on the opposite side of the first bonding part is 5 pieces/$cm^2$ or less.

**2.** The production method according to claim 1,
wherein the organic material has at least one selected from the group consisting of an alkenyl group, a hydroxyl group, a hydrolyzable silyl group, an isocyanate group, an epoxy group, an amino group, an acid anhydride group and a siloxane bond.

**3.** The method for producing a layered product according to claim 1 or 2,
wherein the organic material includes at least one selected from the group consisting of:

(i) a hydrocarbon compound having an alkenyl group at two terminal parts;
(ii) a substituted or unsubstituted hydrocarbon compound having an alkenyl group at one terminal part, and any one selected from the group consisting of a hydroxy group, a hydrolyzable silyl group, an isocyanate group, an epoxy group, an amino group, and an acid anhydride group at another terminal part;
(iii) a substituted or unsubstituted hydrocarbon compound having a plurality of terminal parts, wherein at least two terminal parts, each independently have any one selected independently from a hydroxyl group, a hydrolyzable silyl group, an isocyanate group, an epoxy group, an amino group, a phosphate group, and an acid anhydride group; and
(iv) silsesquioxane and a derivative thereof.

**4.** The production method according to any one of claims 1 to 3, wherein the reaction product is derived from the inorganic material.

**5.** The production method according to claim 4, wherein the reaction product includes at least one selected from the group consisting of $SiO_2$, SiOC, SiOF, SiN, SiCN, $HfO_2$, and $La_2O_3$.

**6.** The production method according to any one of claims 1 to 5, comprising filtering a second composition for purification into the first composition.

**7.** The production method according to claim 6, wherein the filtering is performed using a membrane having an effective diameter of 50 nm or less.

**8.** The production method according to claim 6 or 7, wherein the amount of particles in the second composition is more than 3,000 pieces/mL.

**9.** The production method according to any one of claims 1 to 8, wherein a bonding strength between the first silicon substrate and the second silicon substrate is 1.00 J/$m^2$ or more.

**10.** The production method according to any one of claims 1 to 9, wherein the first adhesive part includes two or more layers.

**11.** The production method according to any one of claims 1 to 10,

wherein the adhesive layer further has a second adhesive part bonding to the first adhesive part,
the second adhesive part is disposed on the second bonding part, and
the number of clusters of particles included in the surface of the second adhesive part on the opposite side of the second bonding part is 5 pieces/$cm^2$ or less.

**12.** The production method according to claim 11, wherein the second adhesive part includes two or more layers.

**13.** The production method according to claim 11 or 12,
wherein the organic material comprises at least one selected from the group consisting of:

(i) a substituted or unsubstituted hydrocarbon compound having a plurality of terminal parts, wherein at least two terminal parts have an alkenyl group;
(ii) a substituted or unsubstituted hydrocarbon compound having a plurality of terminal parts, wherein at least one terminal part has an alkenyl group, and at least one terminal part has any one selected from the group consisting of a hydroxyl group, a hydrolyzable silyl group, an isocyanate group, an epoxy group, an amino group, and an acid anhydride group;
(iii) a substituted or unsubstituted hydrocarbon compound having a plurality of terminal parts, wherein at least two terminal parts, each independently have any one selected independently from the group consisting of a hydroxyl group, a hydrolyzable silyl group, an isocyanate group, an epoxy group, an amino group, a phosphate group, and an acid anhydride group;
(iv) silsesquioxane and a derivative thereof;
(v) a hydrolyzable hydrosilane or a combination of a substituted or unsubstituted hydrocarbon compound having a hydrolyzable silyl group at one terminal part and a hydrosilyl group at the other terminal part, and a substituted or unsubstituted hydrocarbon compound having a hydrolyzable silyl group at one terminal part and an alkenyl group at the other terminal part; and
(vi) a substituted or unsubstituted hydrocarbon compound having a hydrolyzable silyl group at one terminal part and an alkyl group at the other terminal part.

**14.** A layered product comprising:

a first silicon substrate having a first bonding part;
a second silicon substrate having a second bonding part which is located on the side of the first bonding part; and an adhesive layer that is located between the first bonding part and the second bonding part and that allows the first bonding part and the second bonding part to adhere to each other;
wherein the first bonding part and the second bonding part have a hydrosilyl group and/or a silanol group derived from silicon oxide, or a region bonding to an inorganic material;
the adhesive layer includes a reaction product of a reaction with the hydrosilyl group and/or the silanol group, or a region bonding to the inorganic material;
the number of clusters of particles on the surface of the adhesive layer is 5 pieces/$cm^2$ or less; and
the bonding strength between the first silicon substrate and the second silicon substrate is 1.00 J/$m^2$ or more.

**15.** The layered product according to claim 14, wherein the adhesive layer includes 2 or more layers.

**16.** A composition comprising at least one of an organic material and an inorganic material, and having an amount of particles of 3,000 pieces/mL or less.

**17.** The composition according to claim 16, for use in the production method according to claim 1.

[Fig. 1]

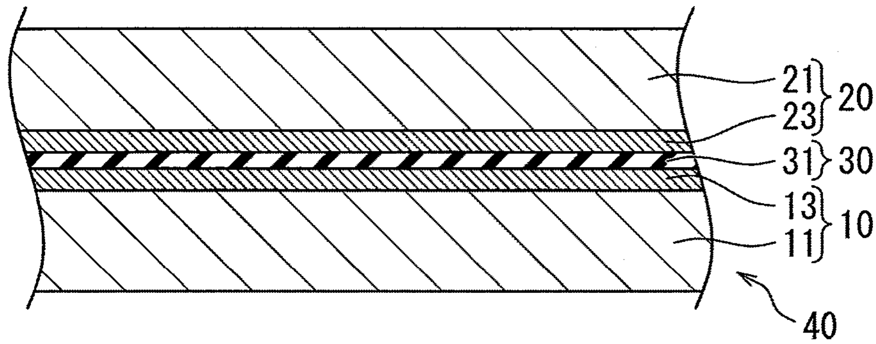


[Fig. 2]

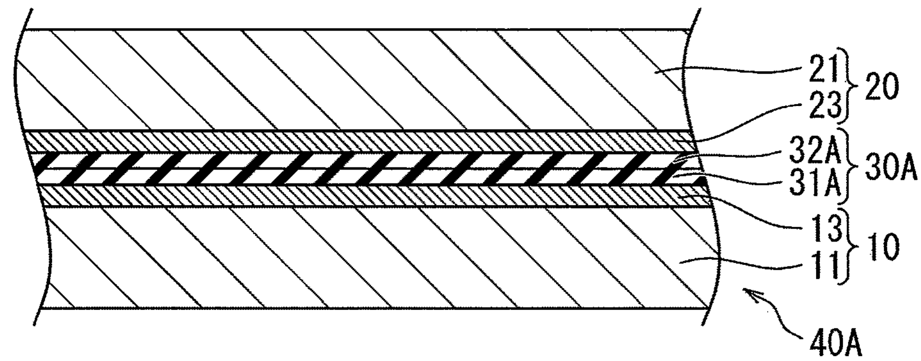

[Fig. 3]

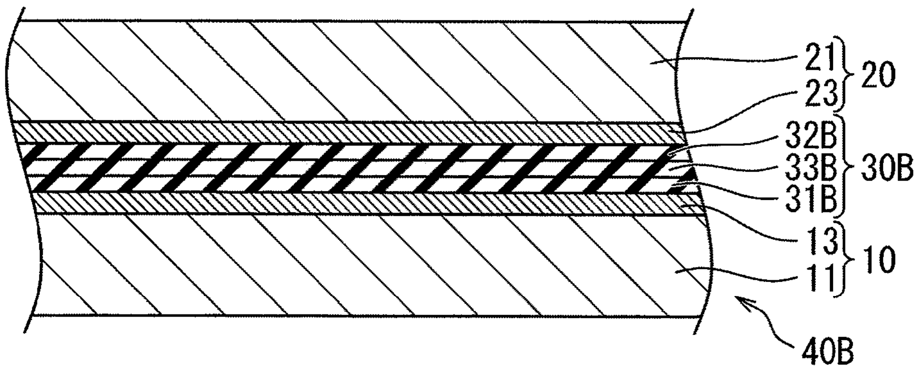

## INTERNATIONAL SEARCH REPORT

International application No.
**PCT/JP2025/008042**

**A. CLASSIFICATION OF SUBJECT MATTER**

***H01L 21/02***(2006.01)i; ***B32B 15/01***(2006.01)i; ***C09J 183/00***(2006.01)i
FI: H01L21/02 B; H01L27/12 B; B32B15/01 J; C09J183/00

According to International Patent Classification (IPC) or to both national classification and IPC

**B. FIELDS SEARCHED**

Minimum documentation searched (classification system followed by classification symbols)

H01L21/02; B32B15/01; C09J183/00

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2020-100818 A (CANON KABUSHIKI KAISHA) 02 July 2020 (2020-07-02) abstract, paragraph [0053] | 16 |
| A | | 1-15, 17 |
| A | JP 5-90116 A (SHIN-ETSU HANDOTAI CO., LTD.) 09 April 1993 (1993-04-09) entire text, all drawings | 1-15, 17 |
| A | JP 2010-189518 A (SEIKO EPSON CORPORATION) 02 September 2010 (2010-09-02) entire text, all drawings | 1-15, 17 |
| A | WO 2023/276638 A1 (DAIKIN INDUSTRIES, LTD.) 05 January 2023 (2023-01-05) entire text, all drawings | 1-15, 17 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 May 2025** | **27 May 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2025/008042**

| Patent document cited in search report | Publication date (day/month/year) | Patent family member(s) | Publication date (day/month/year) |
|---|---|---|---|
| JP 2020-100818 A | 02 July 2020 | US 2020/0198311 A1<br>abstract, paragraph [0054]<br>KR 10-2020-0077417 A | |
| JP 5-90116 A | 09 April 1993 | (Family: none) | |
| JP 2010-189518 A | 02 September 2010 | US 2010/0206474 A1<br>entire text, all drawings<br>CN 101805565 A | |
| WO 2023/276638 A1 | 05 January 2023 | US 2024/0190105 A1<br>entire text, all drawings<br>EP 4362064 A1<br>CN 117529795 A<br>KR 10-2024-0012544 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2023276638 A1